# EUROPÄISCHE PATENTSCHRIFT

(11) **EP 2 135 103 B1**
(45) Veröffentlichungstag und Bekanntmachung des Hinweises auf die Patenterteilung: **06.10.2010**
(21) Anmeldenummer: 09710349.3
(22) Anmeldetag: 12.02.2009
(51) Int. Cl.: G01R 31/28

(54) **VORRICHTUNG UND VERFAHREN ZUM AUSRICHTEN UND HALTEN EINER MEHRZAHL SINGULIERTER HALBLEITERBAUELEMENTE IN AUFNAHMETASCHEN EINES KLEMMTRÄGERS**
DEVICE AND METHOD FOR ALIGNING AND HOLDING A PLURALITY OF SINGULATED SEMI-CONDUCTOR COMPONENTS IN RECEIVING POCKETS OF A TERMINAL CARRIER
DISPOSITIF ET PROCÉDÉ D'ALIGNEMENT ET DE FIXATION D'UNE PLURALITÉ DE COMPOSANTS À SEMI-CONDUCTEUR SINGULIERS DANS DES COMPARTIMENTS DE RÉCEPTION D'UN PORTE-BROCHES

(30) Priorität: 15.02.2008 DE 102008009500
(43) Veröffentlichungstag der Anmeldung: 23.12.2009
(73) Patentinhaber: Multitest elektronische Systeme GmbH, 83026 Rosenheim (DE)
(72) Erfinder: HOFMANN, Thomas, 83071 Stephanskirchen (DE); SCHAULE, Max, 87719 Mindelheim (DE)
(74) Vertreter: Dilg, Haeusler, Schindelmann Patentanwaltsgesellschaft mbH
(86) Internationale Anmeldenummer: PCT/EP2009/000994
(87) Internationale Veröffentlichungsnummer: WO 2009/100910

(56) Entgegenhaltungen:
- US-A1- 2003 017 629
- US-A1- 2006 154 386
- US-B2- 7 156 680

## Beschreibung

Die Erfindung betrifft eine Vorrichtung und ein Verfahren zum Ausrichten und Halten einer Mehrzahl singulierter Halbleiterbauelemente in Aufnahmetaschen eines plattenartigen Klemmträgers gemäß dem Oberbegriff des Anspruches 1 bzw. 13 und 14. US 2003/017629 A1 offenbart eine solche Vorrichtung und ein solches Verfahren.

Halbleiterbauelemente, wie beispielsweise BGAs (Ball Grid Arrays), MLFs, QFNs, Halbleiterbauelemente mit Pins etc., werden üblicherweise nach ihrer Herstellung elektrischen und/oder mechanischen Funktionstests unterzogen. Hierzu werden Handhabungsautomaten, auch Handler genannt, verwendet, welche die Halbleiterbauelemente mit hohen Geschwindigkeiten mit einer Testvorrichtung kontaktieren und nach Durchführung des Funktionstests wieder von dieser entfernen, um sie in Abhängigkeit des Testergebnisses zu sortieren. Häufig wird der Funktionstest unter bestimmten Temperaturbedingungen durchgeführt, wobei der Temperaturbereich von -60°C bis +160°C reichen kann.

Die zu testenden Halbleiterbauelemente liegen üblicherweise in zwei verschiedenen Arten vor, nämlich als singulierte Bauelemente oder als streifenförmiger Verbund ("Strips"). Singulierte Bauelemente haben untereinander keine Verbindung, so dass jedes Bauelement in einem Handler üblicherweise einzeln oder in kleinen Gruppen angesaugt und zu einem oder mehreren Kontaktsockeln transportiert wird, die elektrisch mit einer elektronischen Recheneinrichtung der Testvorrichtung verbunden sind. Bei dieser Handhabung von singulierten Bauelementen ist es allerdings notwendig, jedes einzelne Bauelement unmittelbar vor den Kontaktsockeln zu zentrieren, um sicherzustellen, dass die oft sehr klein und dicht nebeneinander angeordneten Anschlusskontakte der Bauelemente genau auf die entsprechenden Kontakte der Kontaktsockel treffen. Weiterhin ist es schon aus Platzgründen meist nur möglich, eine begrenzte Anzahl von Saugstößeln nebeneinander anzuordnen, so dass die Anzahl von Bauelementen, die gleichzeitig getestet werden können, sehr begrenzt ist. Hierdurch wird der Durchsatz des Handlers entsprechend limitiert.

Halbleiterbauelemente, die in der Form eines Strips vorliegen, werden üblicherweise dadurch getestet, dass der Strip in ein sogenanntes Nest eingelegt wird, das an einem Testkopf angedockt wird. Da die Position der einzelnen Bauelemente auf dem Strip und die Position des Strips innerhalb des Nests genau definiert ist, wird durch die Zentrierung des Nests relativ zum Testkopf sichergestellt, dass sich alle Bauelemente in der korrekten Kontaktlage befinden. Die Anzahl von Bauelementen, die bei Vorliegen von Strips gleichzeitig getestet werden können, ist daher wesentlich größer als bei singulierten Bauelementen. Dies bringt Vorteile hinsichtlich des Handlerdurchsatzes.

Um die Vorteile der Stripanordnung auch auf das Testen von singulierten Halbleiterbauelementen zu übertragen, ist es aus der US 7,258,703 B2 bereits bekannt, singulierte Halbleiterbauelemente in voneinander getrennten Aufnahmetaschen eines Klemmträgers aufzunehmen, in den Aufnahmetaschen auszurichten und anschließend den gesamten Klemmträger einem Testkopf zuzuführen, um die einzelnen Bauelemente zu kontaktieren. Dieser bekannte Klemmträger weist im Seitenbereich der Aufnahmetaschen kleine Federplättchen auf, welche die Bauelemente nur in einer Richtung (y-Richtung) gegen gegenüberliegende Anschlagsflächen drücken. Um die Bauelemente auch in x-Richtung auszurichten, muss dort ein komplex aufgebauter Schiebeblock verschoben werden, der den Boden der Aufnahmetaschen bildet und für jede Aufnahmetasche einen Saugkopf aufweist, mit dem die Bauelemente innerhalb der Aufnahmetasche festgesaugt werden. Diese bekannte Vorrichtung ist kompliziert aufgebaut und benötigt viel Platz. Aufgrund dessen ist dieser bekannte Klemmträger nicht für eine größere Anzahl und nicht für sehr kleine Bauelemente geeignet.

Der Erfindung liegt die Aufgabe zugrunde, eine Vorrichtung gemäß dem Oberbegriff des Anspruches 1 zu schaffen, die besonders einfach, platzsparend und kostengünstig aufgebaut und zur Aufnahme einer Vielzahl von Halbleiterbauelementen geeignet ist sowie sicherstellt, dass die Halbleiterbauelemente in den Aufnahmetaschen genau ausgerichtet und sicher gehalten werden. Weiterhin soll ein im Vergleich zum Stand der Technik verbessertes Verfahren geschaffen werden.

Diese Aufgabe wird erfindungsgemäß durch eine Vorrichtung mit den Merkmalen des Anspruchs 1 und durch ein Verfahren gemäß den Merkmalen der Ansprüche 13 und 14 gelöst. Vorteilhafte Ausführungsformen der Erfindung sind in den weiteren Ansprüchen beschrieben.

Bei der erfindungsgemäßen Vorrichtung sind die Federelemente Teil einer Federplatte, die eine Mehrzahl von nebeneinander angeordneten Aussparungen zur Bildung einer entsprechenden Mehrzahl von Aufnahmetaschen für die Halbleiterbauelemente aufweist, wobei die Federelemente einstückig aus der Federplatte geformt sind.

Der erfindungsgemäße Klemmträger kann im Vergleich zu bekannten Klemmträgern einfacher, sehr platzsparend und kostengünstiger ausgebildet werden. Von besonderem Vorteil ist, dass der erfindungsgemäße Klemmträger auch zur Aufnahme einer großen Anzahl von Halbleiterbauelementen geeignet ist, die innerhalb der Aufnahmetaschen schnell und sehr genau ausgerichtet werden können, so dass sie eine genau definierte Position einnehmen. Weiterhin dienen die Federelemente nicht nur zum Ausrichten, sondern auch zum Festklemmen der Halbleiterbauelemente innerhalb der zugehörigen Aufnahmetaschen in der genau ausgerichteten Position, so dass auf weitere Festhaltemittel, beispielsweise in Form von Saugköpfen, verzichtet werden kann. Der gesamte Klemmträger kann insbesondere als dünne Platte ausgebildet werden, auf der die singulierten Halbleiterbauelemente matrixförmig in genau definierter Position und Ausrichtung festgehalten werden. Die Halbleiterbauelemente können daher, obwohl es sich um singulierte Bausteine handelt, in Handlern getestet werden, die gleich oder ähnlich zu Handlern aufgebaut sind, die für das Testen von Strips verwendet werden.

Gemäß einer vorteilhaften Ausführungsform besteht die Federplatte aus einer ebenen Platte und die Federelemente aus Federzungen, die in der Ebene der Federplatte oder parallel zu dieser Ebene angeordnet und bewegbar sind. Hierdurch kann die Federplatte eine sehr geringe Höhe von beispielsweise nur 0,1 bis 1 mm aufweisen.

Gemäß einer vorteilhaften Ausführungsform besteht der Klemmträger aus einem mehrlagigen Plattenverbund, der die Federplatte und eine zur Federplatte benachbarte Basisplatte und/oder Abdeckplatte umfasst, wobei sich die Federplatte zumindest über den überwiegenden Teil der Basisplatte oder Abdeckplatte erstreckt. Die Basisplatte und/oder Abdeckplatte können hierbei unterschiedliche Funktionen haben, beispielsweise können sie die Federelemente senkrecht zur Hauptebene der Federplatten stabilisieren, Anschlagelemente für die Halbleiterbauelemente tragen oder Zentriermittel für eine Betätigungsvorrichtung für die Federelemente aufweisen. Hierdurch ist es auf besonders effektive Weise möglich, die Bauhöhe des Klemmträgers zu reduzieren, so dass der gesamte Klemmträger die Form einer dünnen Platte hat, deren Höhe weniger als 1 mm betragen kann. Je nach Anwendungsfall ist es jedoch auch möglich, insbesondere die Federplatte und/oder Abdeckplatte wesentlich dicker auszuführen, beispielsweise um die Tiefe der Aufnahmetaschen zu vergrößern.

Falls eine Basisplatte vorhanden ist, ist es vorteilhaft, wenn die Basisplatte als ebene Platte ausgebildet ist, welche die Böden der Aufnahmetaschen bildet.

Gemäß einer vorteilhaften Ausführungsform weist der Klemmträger pro Aufnahmetasche mindestens zwei winklig zueinander angeordnete Federelemente mit unterschiedlich starken Federkräften auf, durch welche die Halbleiterbauelemente in zwei unterschiedlichen Richtungen gegen die Anschlagelemente drückbar sind, wobei die Federelemente mit der Betätigungsvorrichtung derart zusammen wirken, dass das Federelement mit der schwächeren Federkraft das Halbleiterbauelement zuerst und das Federelement mit der stärkeren Federkraft das Halbleiterbauelement erst nachfolgend gegen das jeweils zugeordnete, gegenüberliegende Anschlagelement drückt. Dadurch, dass zuerst das Federelement mit der schwächeren Federkraft das Halbleiterbauelement gegen das gegenüberliegende, erste Anschlagelement drückt, wird auf einfache Weise sichergestellt, dass auch das Federelement mit der stärkeren Federkraft das Bauelement in Richtung zum gegenüberliegenden zweiten Anschlagelement verschieben kann, ohne dass das Bauelement in einer Zwischenposition festklemmt. Die Federkraft des stärkeren Federelements ist somit derart bemessen, dass sie die durch das schwächere Federelement verursachten Haltekräfte überwinden kann.

Gemäß einer vorteilhaften Ausführungsform weist die Federplatte pro Aufnahmetasche einen schwimmend befestigten Federplattenabschnitt auf, der mit Zentriermitteln versehen ist und mindestens ein Federelement sowie die Aussparung zum Einführen des Halbleiterbauelements aufweist. Hierdurch ist es möglich, den schwimmend befestigten Federplattenabschnitt und damit das Halbleiterbauelement auf sehr genaue und leichtgängige Weise beispielsweise gegenüber einem Kontaktsockel oder DUT-Board zu zentrieren, wenn der Klemmträger in die Kontaktposition gefahren wird.

Gemäß einer vorteilhaften Ausführungsform sind zwischen der Basisplatte und der Federplatte und/oder zwischen der Federplatte und der Abdeckplatte Abstandshalter angeordnet, welche die Federplatte auf Abstand zur Basisplatte bzw. zur Abdeckplatte halten. Hierdurch kann bewirkt werden, dass sich die Federelemente mit wesentlich reduzierten oder gänzlich ohne Reibungsverluste zwischen der Basisplatte und der Abdeckplatte bewegen können, so dass die Bauelemente von den Federelementen immer mit genau definierten Druckkräften gegen die gegenüberliegenden Anschlagelemente gedrückt werden.

Die Anschlagelemente zum genauen Positionieren der Halbleiterbauelemente können entweder an der Abdeckplatte oder direkt an der Federplatte angeordnet sein. Zweckmäßigerweise bestehen die Anschlagelemente aus zwei aneinander angrenzenden, rechtwinklig zueinander angeordneten Seitenflächen der Abdeckplatte oder Federplatte, welche die Aufnahmetaschen begrenzen.

Gemäß einer vorteilhaften Ausführungsform ist der Klemmträger zum Aufnehmen von Pins aufweisenden Halbleiterbauelementen ausgebildet, wobei die Basisplatte Pinabschnittselemente aufweist, die sich durch die Aussparungen der Federplatte hindurch erstrecken, um eine Auflage für die Pins zu bilden. Derartige Pinabschnittselemente, die auch "Leadbacker" genannt werden, unterstützen die Pins beim Kontaktieren an den Kontaktelementen des Testkopfs, so dass die Pins nicht weg gebogen werden können.

Gemäß einer vorteilhaften Ausführungsform bestehen die Pinabschnittselemente aus Plattenabschnitten, die einstückig aus der Basisplatte geformt und relativ zur Basisplattenebene senkrecht abgewinkelt sind. Hierdurch ist es nicht erforderlich, die Pinabschnittselemente nachträglich auf einer der Platten zu montieren.

Alternativ hierzu ist es auch möglich, die Abdeckplatte aus einem elektrisch isolierenden Material herzustellen, wobei die Abdeckplatte neben den Aussparungen angeordnete Pinabstützabschnittc aufweist, die eine Auflage für die Pins bilden. Hierdurch lässt sich die Auflage für die Pins auf sehr einfache Weise herstellen. Insbesondere ist es nicht erforderlich, an der Basisplatte gebildete Pinabschnittselemente durch Öffnungen in der Federplatte hindurch zu führen, so dass eine größere Gestaltungsfreiheit bei der Konstruktion der Basisplatte und Federplatte gegeben ist.

Gemäß einer vorteilhaften Ausführungsform weist der Klemmträger zwei oder mehrere übereinander angeordnete Federplatten auf, an denen die Federelemente angeordnet sind. Hierdurch ist es möglich, dass sich die Federelemente besser an Schrägflächen des Bauelementkörpers anpassen können.

Gemäß einer vorteilhaften Ausführungsform weist die Betätigungsvorrichtung eine parallel zur Klemmträgerebene angeordnete Hauptplatte und von der Hauptplatte abstehende Betätigungsglieder auf, die bei Annäherung der Betätigungsvorrichtung an den Klemmträger mit den Federelementen in Eingriff treten, um diese seitlich nach außen in eine Öffnungsstellung zu drücken. Hierbei ist es insbesondere möglich, dass die Betätigungsglieder aus Keilelementen mit Schrägflächen bestehen, die mit den Federelementen in und außer Eingriff bringbar sind. Alternativ hierzu ist es jedoch auch denkbar, dass die Betätigungsglieder, nachdem sie mit den Federelementen in Eingriff gebracht worden sind, seitlich nach außen bewegt werden, um die Federelemente in eine Öffnungsstellung zu überführen, die das Einsetzen der Halbleiterbauelemente in die Aufnahmetaschen ermöglicht.

Gemäß einer vorteilhaften Ausführungsform sind die Betätigungsglieder der Betätigungsvorrichtung derart ausgebildet und relativ zu den Federelementen angeordnet, dass in einer bestimmten Position der Betätigungsvorrichtung das Federelement mit der stärkeren Federkraft noch in Druckeingriff mit dem zugeordneten Betätigungsglied ist, während das Federelement mit der schwächeren Federkraft bereits außer Druckeingriff mit dem zugeordneten Betätigungsglied ist. Da hierbei das Federelement mit der schwächeren Druckkraft zuerst von der Betätigungsvorrichtung freigegeben wird, wird auf diese Weise sichergestellt, dass das Federelement mit der schwächeren Druckkraft das Halbleiterbauelement an das gegenüberliegende Anschlagelement drückt, bevor dies vom Federelement mit der stärkeren Federkraft durchgeführt wird.

Alternativ oder zusätzlich ist es auch möglich, dass das Federelement mit der schwächeren Federkraft eine mit dem Halbleiterbauelement in Kontakt bringbare erste Druckfläche und das Federelement mit der stärkeren Federkraft eine mit dem Halbleiterbauelement in Kontakt bringbare zweite Druckfläche aufweist, wobei die erste Druckfläche zum gegenüberliegenden Anschlagelement einen kleineren Abstand hat als die zweite Druckfläche zum gegenüberliegenden Anschlagelement, so dass ein Halbleiterbauelement mit einem quadratischen Körper zuerst vom Federelement mit der schwächeren Federkraft an das gegenüberliegende Anschlagelement gedrückt wird.

Das erfindungsgemäße Verfahren ist **dadurch gekennzeichnet, dass** ein Klemmträger bereit gestellt wird, der pro Aufnahmetasche mindestens zwei winklig zueinander angeordnete Federelemente mit unterschiedlich starken Federkräften aufweist, um die Halbleiterbauelemente in zwei unterschiedlichen Richtungen gegen die Anschlagelemente zu drücken, und dass die Betätigungsvorrichtung nach dem Einsetzen der Halbleiterbauelemente in die Aufnahmetaschen von den Federelementen derart gelöst wird, dass das Federelement mit der schwächeren Federkraft das Halbleiterbauelement zuerst und das Federelement mit der stärkeren Federkraft das Halbleiterbauelement erst nachfolgend gegen das jeweils zugeordnete, gegenüberliegende Anschlagelement drückt.

Ein alternatives erfindungsgemäßes Verfahren ist **dadurch gekennzeichnet, dass** ein Klemmträger bereit gestellt wird, der pro Aufnahmetasche mindestens zwei winklig zueinander angeordnete Federelemente mit unterschiedlich starken Federkräften aufweist, um die Halbleiterbauelemente in zwei unterschiedlichen Richtungen gegen die Anschlagelemente zu drücken, und dass die winklig zueinander angeordneten Federelemente nach dem Einsetzen der Halbleiterbauelemente in die Aufnahmetaschen mittels der Betätigungsvorrichtung derart verschoben werden, dass das Federelement mit der schwächeren Federkraft das Halbleiterbauelement zuerst und das Federelement mit der stärkeren Federkraft das Halbleiterbauelement erst nachfolgend gegen das jeweils zugeordnete, gegenüberliegende Anschlagelement drückt.

Die mit den erfindungsgemäßen Verfahren erzielten Vorteile entsprechen denjenigen, die im Zusammenhang mit der erfindungsgemäßen Vorrichtung beschrieben worden sind.

Die Erfindung wird nachfolgend anhand der Zeichnungen beispielhaft näher erläutert. Es zeigen:
- Figur 1 :: Eine Explosionsdarstellung eines Abschnitts der erfindungsgemäßen Vorrichtung mit Klemmträger und Betätigungsvorrichtung,
- Figur 2 :: eine Einzeldarstellung einer Abdeckplatte,
- Figur 3 :: eine vergrößerte Darstellung der Einzelheit III von Figur 2,
- Figur 4 :: eine Einzeldarstellung einer Basisplatte,
- Figur 5 :: eine vergrößerte Darstellung der Einzelheit V von Figur 4,
- Figur 6 :: eine Einzeldarstellung einer Federplatte,
- Figur 7 :: eine vergrößerte Darstellung der Einzelheit VII von Figur 6,
- Figuren 8 und 9 :: eine Draufsicht schräg von oben bzw. schräg von unten der Betätigungsvorrichtung von Figur 1,
- Figuren 10 bis 14 :: verschiedene Stadien beim Einsetzen eines Halbleiterbauelements in eine Aufnahmeta- sche,
- Figur 15 :: eine alternative Ausführungsform einer Be- tätigungsvorrichtung,
- Figur 16 :: eine Explosionsdarstellung einer weiteren Ausführungsform der erfindungsgemäßen Vor- richtung,
- Figur 17 :: eine Ansicht schräg von oben auf die Feder- platten und die Basisplatte von Figur 16, wobei die Abdeckplatte der Übersichtlich- keit halber weggelassen und die Betäti- gungsvorrichtung in der Öffnungsstellung gezeigt ist,
- Figur 18 :: eine Darstellung entsprechend Figur 17 mit eingesetzten Halbleiterbauelementen und angehobener Betätigungsvorrichtung,
- Figur 19 :: eine Darstellung entsprechend Figur 18 mit Abdeckplatte,
- Figur 20 :: einen Querschnitt durch eine weitere Aus- führungsform eines Klemmträgers mit einge- setztem Halbleiterbauelement,
- Figur 21 :: einen Abschnitt der in Figur 20 verwendeten Basisplatte,
- Figur 22 :: eine Draufsicht auf den Klemmträger von Figur 20 im Bereich einer Aufnahmetasche ohne Halbleiterbauelement,
- Figur 23 :: eine weitere Ausführungsform einer Basis-
- Figur 24 :: platte, eine weitere Ausführungsform der erfin- dungsgemäßen Vorrichtung,
- Figur 25 :: eine Draufsicht auf eine weitere Ausfüh- rungsform einer erfindungsgemäßen Feder- platte,
- Figur 26 :: das Detail XXVI von Figur 25 in vergrößer- ter Darstellung,
- Figur 27 :: eine Draufsicht schräg von oben auf eine weitere Ausführungsform einer erfindungs- gemäßen Federplatte,
- Figur 28 :: das Detail XXVIII von Figur 27 in vergrö- ßerter Darstellung,
- Figur 29 :: eine Draufsicht auf einen Klemmträger gemäß einer weiteren Ausführungsform der Erfin- dung,
- Figur 30 :: das Detail XXX von Figur 29 in vergrößerter Darstellung,
- Figur 31 :: einen Längsschnitt entlang der Linie A-A von Figur 29, wobei sich das Federelement und das Halbleiterbauelement in der Ein- führstellung befinden, und
- Figur 32 :: eine Darstellung entsprechend Figur 31, wobei das Halbleiterbauelement durch das Federelement in die zentrierte Haltestel- lung gedrückt ist.

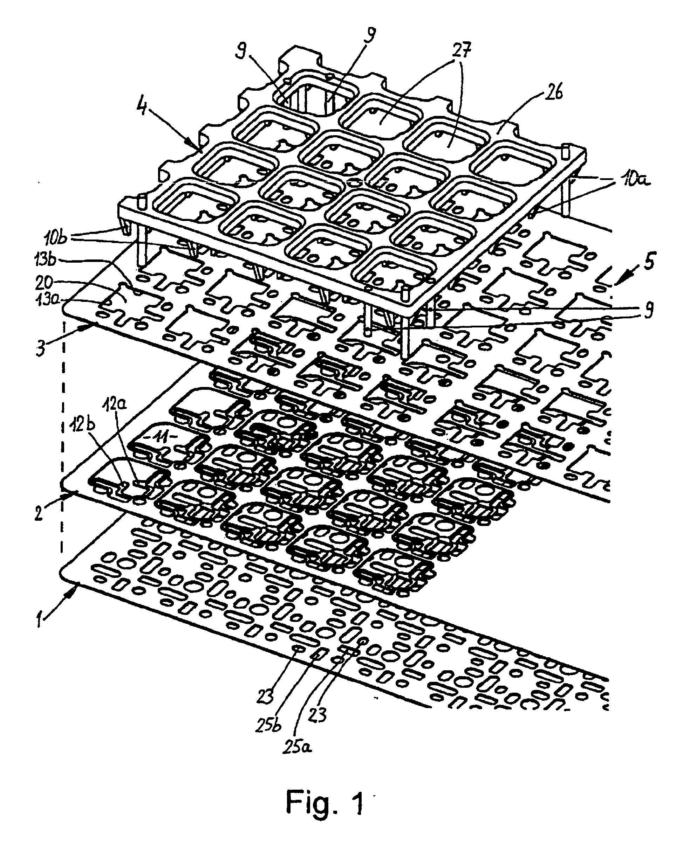

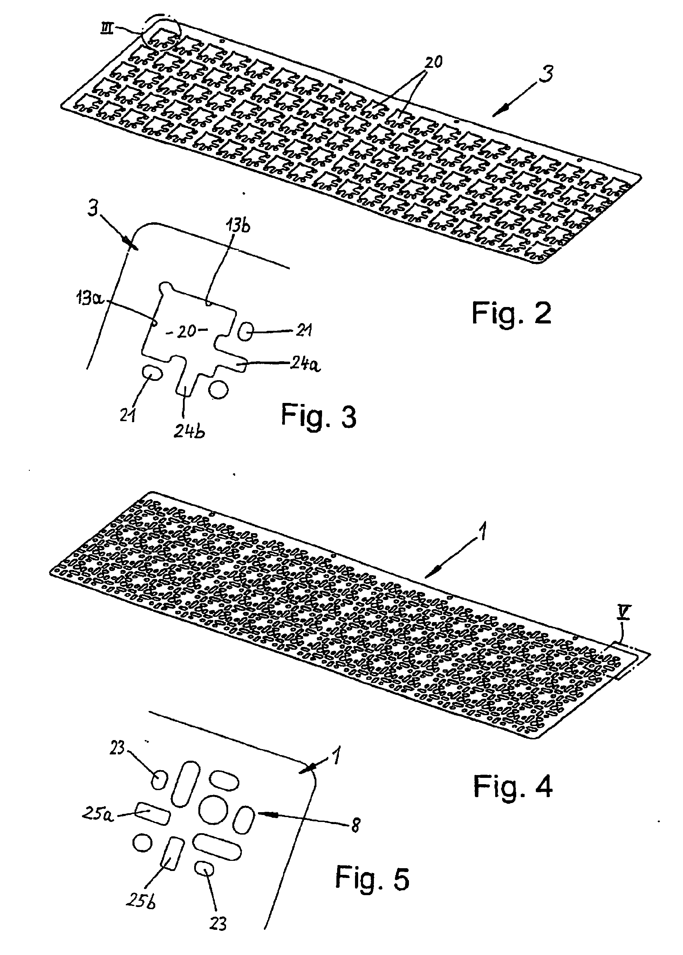

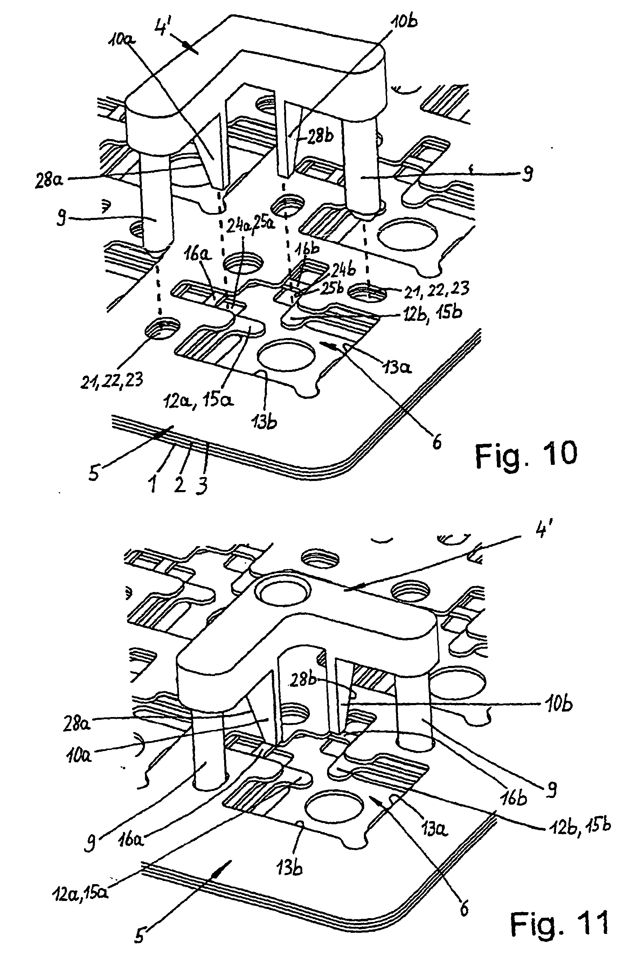

Aus Figur 1 ist ein Endabschnitt eines ersten Ausführungsbeispiels einer erfindungsgemäßen Vorrichtung ersichtlich. Diese Vorrichtung besteht aus einer Basisplatte 1, einer Federplatte 2, einer Abdeckplatte 3 und einer Betätigungsvorrichtung 4. Bei den Platten 1, 2, 3 handelt es sich jeweils um dünne, planparallele Platten, beispielsweise in der Form von länglichen Metallstreifen, wie sie in den Figuren 2, 4, 6 dargestellt sind. Die Platten 1, 2, 3 weisen die gleichen Außenabmessungen auf und sind, wie beispielsweise aus Figur 10 ersichtlich, aufeinander angeordnet, so dass sie einen dreilagigen Plattenverbund ergeben. Die Verbindung der Platten 1, 2, 3 untereinander kann beispielsweise durch Schweißen, Kleben oder Schrauben erfolgen.

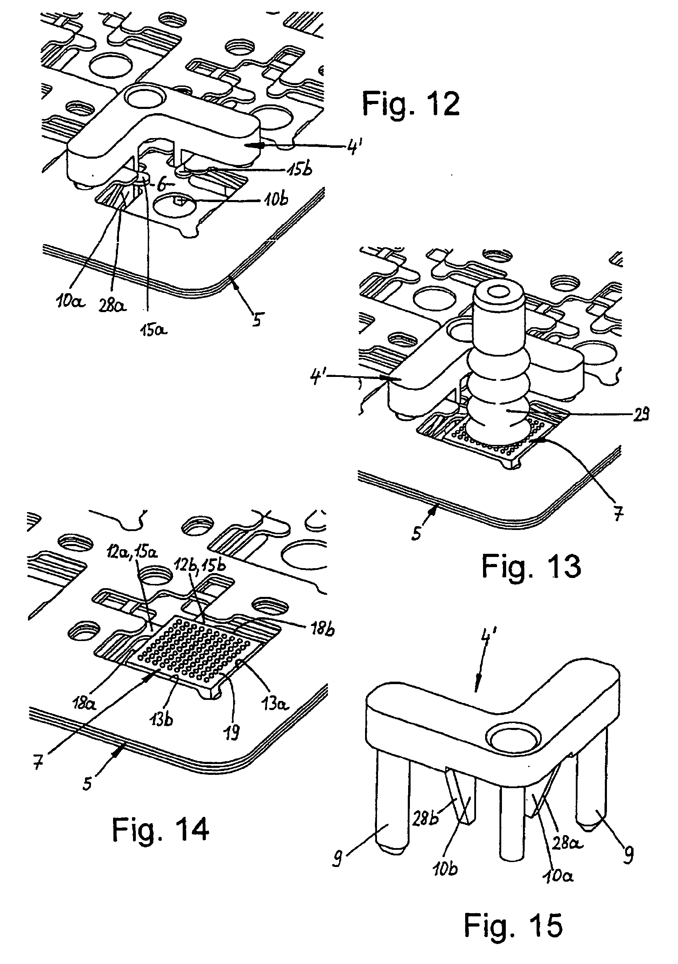

Die Platten 1, 2, 3 bilden zusammen einen Klemmträger 5 mit einer Vielzahl von matrixförmig angeordneten Aufnahmetaschen 6, in die Halbleiterbauelemente 7 eingesetzt werden können, wie beispielsweise aus den Figuren 13, 14 ersichtlich.

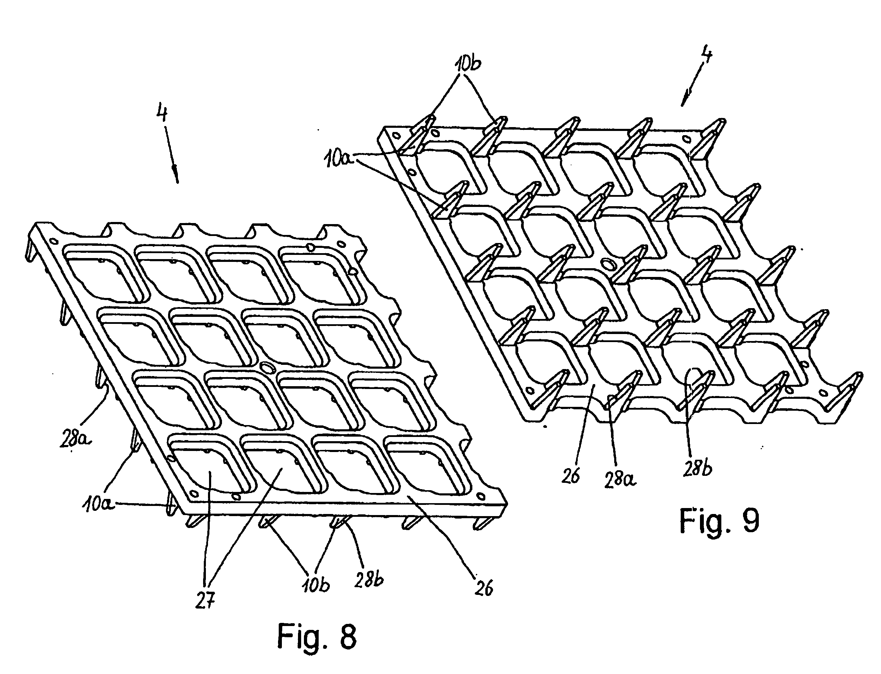

Der in den Figuren 1, 10 bis 14 gezeigte Klemmträger 5 ist derart konzipiert, dass er zur Aufnahme von BGAs, MLFs und QFNs geeignet ist. Die unterste Lage des Klemmträgers 5 wird durch die Basisplatte 1 gebildet, die den Boden für die Aufnahmetasche 6 bildet. Die in den Aufnahmetaschen 6 eingesetzten Halbleiterbauelemente 7 liegen somit auf der Basisplatte 1 auf. Alternativ ist es jedoch auch möglich, an der Basisplatte 1 tellerartige Taschenelemente, beispielsweise aus Kunststoff, zu befestigen, welche die Böden für die Aufnahmetaschen 6 bilden und in welche die Bauelemente 7 eingesetzt werden können. Wie aus den Figuren 4 und 5 ersichtlich, weist die Basisplatte 1 eine Vielzahl von Aussparungen 8 auf. In Figur 8 ist eine Gruppe von insgesamt zehn teils länglichen, teils kreisrundförmigen Aussparungen 8 ersichtlich, wobei jeder Aufnahmetasche 6 eine derartige Gruppe von Aussparungen 8 zugeordnet ist. Die Aussparungen 8 dienen dazu, Zentrierstifte 9 und keilförmige Betätigungsglieder 10 der Betätigungsvorrichtung 4 hindurchtreten zu lassen, wie später noch näher beschrieben wird.

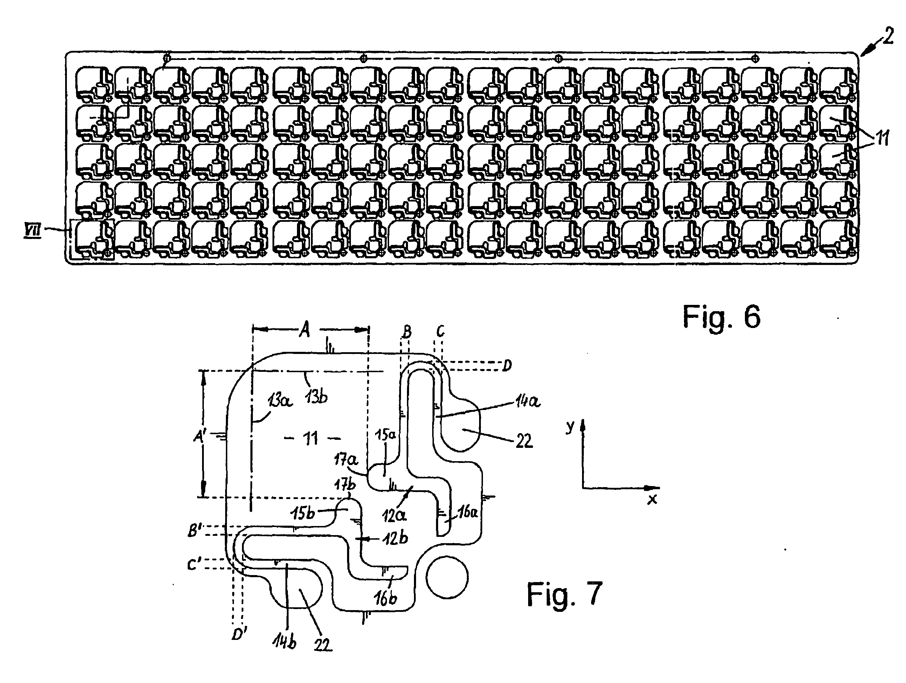

Die Federplatte 2 dient zum Ausrichten und Festklemmen der Halbleiterbauelemente 7 in einer genau vorbestimmten Position innerhalb der Aufnahmetaschen 6. Wie aus Figur 6 ersichtlich, weist die Federplatte 2 eine Vielzahl von gleichen, matrixförmig angeordneten Aussparungen 11 auf. Im gezeigten Ausführungsbeispiel sind fünf nebeneinander angeordnete Reihen von Aussparungen 11 vorgesehen, wobei jede Reihe zwanzig Aussparungen 11 enthält. Die Aussparungen 11 bilden den unteren Abschnitt der Aufnahmetaschen 6. Im vorliegenden Ausführungsbeispiel weist der Klemmträger 5 somit hundert Aufnahmetaschen 6 auf, die in einer 5 x 20 Matrix angeordnet sind. Die Anzahl und Anordnung der Aufnahmetaschen 6 kann jedoch je nach Anwendungsfall in weitem Umfang variieren.

An zwei verschiedenen Seiten einer jeden Aussparung 11 der Federplatte 2 sind zwei Federelemente 12a, 12b angeordnet, deren Längsrichtungen in einem rechten Winkel zueinander verlaufen. Die Federelemente 12a, 12b dienen dazu, ein in die Aussparung 11 eingesetztes Halbleiterbauelement 7 gegen gegenüberliegende Anschlagelemente in Form von Anschlagflächen 13a, 13b (Figur 14) zu drücken, welche sich an der Abdeckplatte 3 befinden, die auf der Federplatte 2 angeordnet ist. Die Lage der Anschlagflächen 13a, 13b relativ zur zugehörigen Aussparung 11 der Federplatte 2 ist in Figur 7 mit strichpunktierten Linien angedeutet. Die rechtwinklig zueinander angeordneten Anschlagflächen 13a, 13b dienen dazu, das Halbleiterbauelement 7 innerhalb der Aufnahmetaschen 6 relativ zur Abdeckplatte 3 und damit zum gesamten Klemmträger 5 genau zu positionieren, und zwar in zwei verschiedenen Richtungen, d.h. sowohl in x- als auch in y-Richtung.

Die Federelemente 12a, 12b sind als Federzungen ausgebildet und einstückig aus der Federplatte 2 herausgeformt, beispielsweise mittels eines lithographischen Ätzverfahrens. Die beiden Federelemente 12a, 12b haben eine ganz ähnliche Form und weisen jeweils einen U-förmigen Federabschnitt 14a, 14b, einen am freien Ende des Federabschnitts 14a, 14b angeordneten Drückabschnitt 15a, 15b und einen am freien Ende der Federelemente 12a, 12b angeordneten Betätigungsabschnitt 16a, 16b auf. Die Drückabschnitte 15a, 15b weisen abgerundete Druckflächen 17a, 17b auf, die in x- bzw. y-Richtung über den U-förmigen Federabschnitt 14a, 14b vorstehen und in Kontakt mit den benachbarten Seitenflächen 18a, 18b des Körpers 19 des Halbleiterbauelements 7 (Figur 14) gebracht werden können.

Der Betätigungsabschnitt 16a, 16b stellt das freie Ende der bügelförmigen Federelemente 12a, 12b dar. Beim Einführen der Betätigungsglieder 10 der Betätigungsvorrichtung 4 in den Klemmträger 5 gelangen die Betätigungsglieder 10 mit der Innenseite der Betätigungsabschnitte 16a, 16b derart in Eingriff, dass die Betätigungsabschnitte 16a, 16b und damit die Federelemente 12a, 12b entgegen ihrer Federkraft und zunehmend seitlich nach außen gedrückt werden, wodurch sich die Druckflächen 17a, 17b zunehmend von den gegenüberliegenden Anschlagflächen 13a, 13b entfernen und sich der Einsetzraum für das Halbleiterbauelement 7 erweitert. Werden die Betätigungsglieder 10 von den Betätigungsabschnitten 16a, 16b der Federelemente 12a, 12b wieder entfernt, können die Federkräfte der Federelemente 12a, 12b frei wirksam werden und das Halbleiterbauelement 7 gegen die gegenüberliegenden Anschlagflächen 13a, 13b drücken.

Die Federelemente 12a weisen eine geringere Federkraft als die Federelemente 12b auf. Dies wird dadurch erzielt, dass die Breiten B, C, D des U-förmigen Federabschnitts 14a geringer sind als die entsprechenden Breiten B', C', D' des U-förmigen Federabschnitts 14b. Weiterhin sind die Federelemente 12a, 12b derart angeordnet, dass der Abstand A zwischen der Druckfläche 17a und der gegenüberliegenden Anschlagfläche 13a kleiner ist als der Abstand A' zwischen der Druckfläche 17b und der gegenüberliegenden Anschlagfläche 13b, wenn sich die Federelemente 12a, 12b in der entspannten Stellung befinden. Hierdurch wird erreicht, dass das Federelement 12a, das die schwächere Federkraft aufweist, das Halbleiterbauelement 7 zuerst gegen die Anschlagfläche 13a drückt und das Federelement 12b, das die stärkere Federkraft aufweist, das Halbleiterbauelement 7 erst nachfolgend gegen die Anschlagfläche 13b drückt, wenn die Betätigungsglieder 10a, 10b der Betätigungsvorrichtung 4 die Betätigungsabschnitte 16a, 16b der Federelemente 12a, 12b gleichzeitig freigeben. Die Federkraft des Federelements 12b ist dabei so bemessen, dass sie die Reibkraft, mit der das schwächere Federelement 12a das Halbleiterbauelement 7 gegen die Anschlagfläche 13a drückt, überwinden und das Halbleiterbauelement 7 bis zur Anschlagfläche 13b verschieben kann, ohne dass das Halbleiterbauelement 7 in einer Zwischenstellung klemmt.

Anstelle unterschiedlicher Abstände A, A' oder zusätzlich zu unterschiedlichen Abständen A, A' ist es auch möglich, die Betätigungsglieder 10a, 10b und die Betätigungsabschnitte 16a, 16b derart relativ zueinander anzuordnen, dass beim Entfernen der Betätigungsglieder 10a, 10b der Betätigungsabschnitt 16a vor dem Betätigungsabschnitt 16b freigegeben wird, um das Halbleiterbauelement 7 zuerst mit der schwächeren Federkraft und erst anschließend mit der stärkeren Federkraft auszurichten.

Wie bereits erwähnt, befinden sich bei dem in den Figuren 1, 10 bis 14 gezeigten Ausführungsbeispielen eines Klemmträgers 5 die Anschlagflächen 13a, 13b, welche für die genaue Ausrichtung der Halbleiterbauelemente 7 in x- und y-Richtung sorgen, an der Abdeckplatte 3, die auf der Federplatte 2 angeordnet ist. Wie aus den Figuren 2 und 3 ersichtlich, weist hierzu die Abdeckplatte 3 Aussparungen 20 auf, die in Anzahl und Anordnung den Aussparungen 11 der Federplatte 2 entsprechen und über den Aussparungen 11 angeordnet sind. Bei den Anschlagflächen 13a, 13b handelt es sich um benachbarte, rechtwinklig zueinander angeordnete Seitenflächen der Aussparungen 20. Alle Anschlagflächen 13a, 13b sind in einer genau definierten Position auf der Abdeckplatte 3 und damit auch relativ zueinander angeordnet, so dass die Halbleiterbauelemente 7, wenn sie an den Anschlagflächen 13a, 13b anliegen, eine genau definierte Position relativ zum Klemmträger 5 haben. Auch eine große Anzahl von Halbleiterbauelementen 7 kann damit in einer genau definierten Position an zugeordnete Kontaktelemente eines Testkopfs herangeführt werden.

Aus Figur 3 sind weiterhin neben den Aussparungen 20 angeordnete Zentrierlöcher 21 ersichtlich, durch welche die Zentrierstifte 9 der Betätigungsvorrichtung 4 hindurch geführt werden können. Diese Zentrierlöcher 21 fluchten mit entsprechenden Zentrieraussparungen 22 in der Federplatte 2 (Figur 7) und entsprechenden Zentrierlöchern 23 in der Basisplatte 1 (Figur 5). Die Zentrierstifte 9 der Betätigungsvorrichtung 4 können damit durch den gesamten Klemmträger 5 hindurch geführt werden.

Weiterhin weisen die Aussparungen 20 der Abdeckplatte 3, wie aus Figur 3 ersichtlich, seitliche Ausbuchtungen 24a, 24b auf, die sich über den Betätigungsabschnitten 16a, 16b der Federelemente 12a, 12b befinden und weiterhin über Aussparungen 25a, 25b in der Basisplatte 1 (Figur 1) angeordnet sind. Die Betätigungsglieder 10a, 10b der Betätigungsvorrichtung 4 können daher durch die Ausbuchtungen 24a, 24b der Abdeckplatte 3, durch die Aussparungen 11 der Federplatte und durch die Aussparungen 25a, 25b der Basisplatte 1 hindurch stoßen, wobei sie mit den Betätigungsabschnitten 16a, 16b der Federelemente 12a, 12b in Eingriff gelangen und diese seitlich nach außen drücken, um den Einsetzraum für die Halbleiterbauelemente 7 in die Aufnahmetaschen 6 zu erweitern und dadurch das Einsetzen der Halbleiterbauelemente 7 zu ermöglichen.

Im Folgenden wird die Betätigungsvorrichtung 4 anhand der Figuren 8 und 9 näher beschrieben. Die in Figur 1 gezeigten Zentrierstifte 9 sind in den Figuren 8 und 9 nicht dargestellt.

Die Betätigungsvorrichtung 4 ist im dargestellten Ausführungsbeispiel als flächiger Öffner ausgebildet, der gleichzeitig eine Vielzahl oder alle Aufnahmetaschen 6 des Klemmträgers 5 öffnen kann. Dementsprechend erstreckt sich die Betätigungsvorrichtung 4 über einen Teil oder über den gesamten Klemmträger 5. In den Figuren 8 und 9 ist lediglich ein Abschnitt der Betätigungsvorrichtung 4 dargestellt, der zum Öffnen von 25 Aufnahmetaschen 6 geeignet ist, die in einer 5 x 5 Matrix vorliegen.

Die Betätigungsvorrichtung 4 weist eine Hauptplatte 26 auf, die parallel zum Klemmträger 5 anordenbar ist. Diese Hauptplatte 26 ist als Lochplatte mit Zentrieröffnungen 27 ausgebildet, die sich über den Aufnahmetaschen 6 befinden. Die Zentrieröffnungen 27 weisen einen Durchmesser auf, der geringfügig größer als die Halbleiterbauelemente 7 sind, so dass die Halbleiterbauelemente 7 einerseits durch die Zentrieröffnungen 27 hindurch geführt werden können und andererseits beim Hindurchführen bezüglich der Aufnahmetaschen 6 vorzentriert werden.

Von der Hauptplatte 26 erstrecken sich die Betätigungsglieder 10a, 10b senkrecht nach unten, wobei die Betätigungsglieder 10a, 10b einstückig mit der Hauptplatte 26 ausgebildet oder nachträglich an diese montiert sein können. Bei den Betätigungsgliedern 10a, 10b handelt es sich um Keilelemente mit Schrägflächen 28a, 28b. Wird die Betätigungsvorrichtung 4 an den Klemmträger 5 angenähert, so dass die Betätigungsglieder 10a, 10b zunehmend in die Aussparungen bzw. Ausbuchtungen des Klemmträgers 5 eingeführt werden, so kommen die Schrägflächen 28a mit den Betätigungsabschnitten 16a der Federelemente 12a in Eingriff, während die Schrägflächen 28b der Betätigungsglieder 10b mit den Betätigungsabschnitten 16b der Federelemente 12b in Eingriff gelangen. Durch das Annähern der Betätigungsvorrichtung 4 an den Klemmträger 5 werden die Federelemente 12a, 12b zunehmend nach außen gedrückt, so dass die Halbleiterbauelemente 7 in die Aufnahmetaschen 6 eingesetzt werden können. Wird die Betätigungsvorrichtung 4 vom Klemmträger 5 wieder entfernt, werden die Federelemente 12a, 12b freigegeben, so dass sie die Halbleiterbauelemente 7 gegen die Anschlagflächen 13a, 13b drücken können, wie vorstehend bereits erläutert.

Das Einsetzen und Ausrichten der Halbleiterbauelemente 7 in den Aufnahmetaschen 6 wird im Folgenden anhand der Figuren 10 bis 15 näher erläutert, welche den gleichen Klemmträger 5 zeigen, wie in Figur 1 dargestellt, jedoch ein alternatives, schematisch dargestelltes Ausführungsbeispiel einer Betätigungsvorrichtung 4'. Die Betätigungsvorrichtung 4' arbeitet jedoch nach dem selben Prinzip wie die Betätigungsvorrichtung 4, so dass die folgenden Ausführungen für beide Ausführungsformen gelten.

In Figur 10 befindet sich die Betätigungsvorrichtung 4' mit Abstand oberhalb des Klemmträgers 5. Die Zentrierstifte 9 fluchten zu den Zentrierlöchern bzw. -aussparungen 21, 22, 23, während sich die Betätigungsglieder 10a, 10b oberhalb der Ausbuchtungen 24a, 24b bzw. Aussparungen 25a, 25b befinden. Die Federelemente 12a, 12b befinden sich in ihrer entspannten, nach innen relativ weit vorstehenden Stellung.

Figur 11 zeigt die Betätigungsvorrichtung 4' in einer abgesenkten Stellung, wobei die Zentrierstifte 9 bereits in Eingriff mit dem Klemmträger 5, die Betätigungsglieder 10a, 10b jedoch noch nicht in Eingriff mit den Federelementen 12a, 12b sind.

Figur 12 zeigt die vollständig abgesenkte Position der Betätigungsvorrichtung 4'. Die Betätigungsglieder 10a, 10b haben den Klemmträger 5 vollkommen durchstoßen. Die Federelemente 12a, 12b werden durch die Schrägflächen 28a, 28b der Betätigungsglieder 10a, 10b seitlich nach außen gedrückt, so dass die Druckabschnitte 15a, 15b der Federelemente 12a, 12b seitlich außerhalb des Einsetzbereiches für die Halbleiterbauelemente 7 angeordnet sind.

Anschließend können, wie aus Figur 13 ersichtlich, die Halbleiterbauelemente 7 mittels einer geeigneten Vorrichtung, beispielsweise mittels eines Saugkopfs 29, in die Aufnahmetaschen 6 eingesetzt werden.

Nach dem Einsetzen der Halbleiterbauelemente 7 werden die Saugköpfe 29 von den Halbleiterbauelementen 7 und die Betätigungsvorrichtung 4' vom Klemmträger 5 entfernt, wie aus Figur 14 ersichtlich. Die Federelemente 12a, 12b drücken aufgrund ihrer Federkraft die Halbleiterbauelemente 7 in der bereits beschriebenen Reihenfolge gegen die gegenüberliegenden Anschlagflächen 13a, 13b. Die Halbleiterbauelemente 7 sind damit im Klemmträger 5 ausgerichtet und festgeklemmt, so dass sie mit dem nicht dargestellten Testkopf kontaktiert werden können. Wahlweise kann auch eine visuelle Inspektion erfolgen oder ein Markieren durch einen Laser.

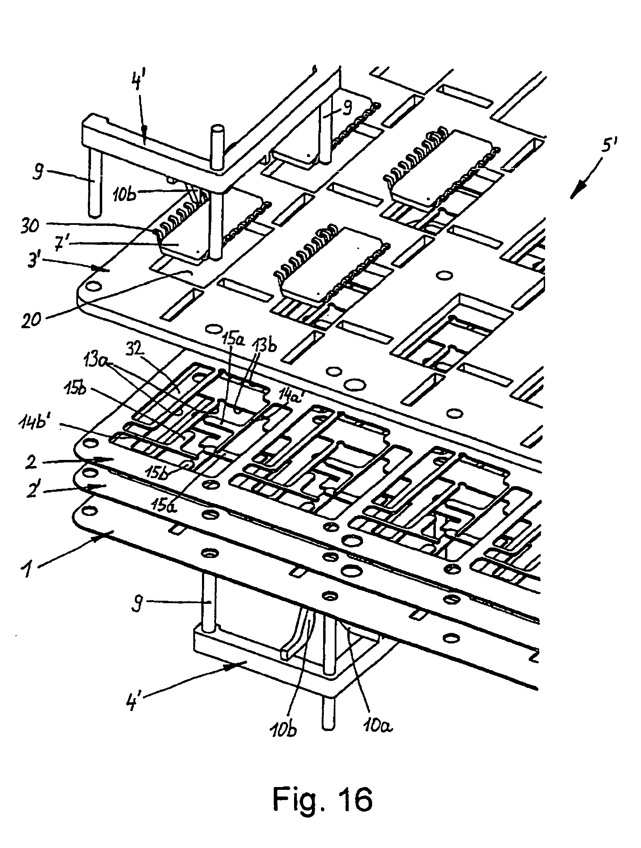

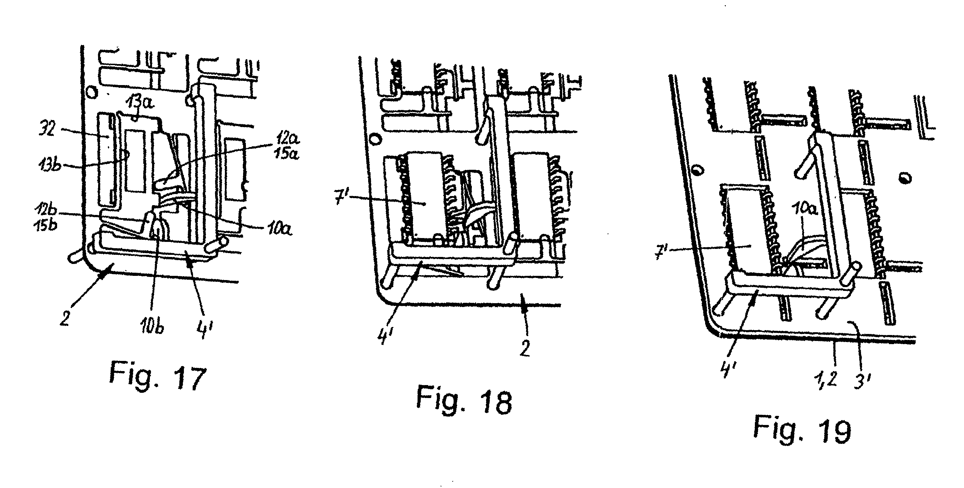

Anhand der Figuren 16 bis 19 wird nachfolgend ein weiteres Ausführungsbeispiel eines erfindungsgemäßen Klemmträgers 5' beschrieben. Dieser Klemmträger 5' unterscheidet sich vom Klemmträger 5 der Figur 1 darin, dass nicht eine, sondern zwei Federplatten 2, 2' übereinander angeordnet sind, dass die Anschlagflächen 13a, 13b nicht an der Abdeckplatte 3', sondern direkt an den Federplatten 2, 2' angeordnet sind, und dass die Abdeckplatte 3' derart ausgebildet ist, dass sie zur Unterstützung von seitlich von Bauelementen 7' abstehenden Pins 30 dienen kann.

Die Basisplatte 1 kann bei dieser Ausführungsform gleich oder ähnlich zur Basisplatte 1 von Figur 1 ausgebildet sein. Es ist auch ohne weiteres möglich, dass die Betätigungsvorrichtung 4' gleich oder ähnlich ausgebildet ist wie die Betätigungsvorrichtung 4' der Figuren 10 bis 15, oder auch gleich oder ähnlich zu der Betätigungsvorrichtung 4 der Figur 1. Weiterhin kann es zweckmäßig sein, dass die Basisplatte 1, wie in Figur 16 dargestellt, derartige Aussparungen aufweist, dass die Betätigungsvorrichtung 4' nicht nur von oben, sondern auch von unten in den Klemmträger 5' eingeführt wird, um die Federelemente 12a, 12b in ihre Öffnungsstellung zu überführen. In diesem Fall ist es möglich, die Halbleiterbauelemente 7' auf alternative Weise in die Aufnahmetaschen 6 des Klemmträgers 5' einzusetzen. Beispielsweise ist es möglich, den Klemmträger 5' in einer um 180° gekippten Stellung, d.h. mit der Abdeckplatte 3' nach unten, mit einem darunter liegenden Transporttray zu verbinden, in dem sich die Halbleiterbauelemente 7' befinden. Anschließend kann der Klemmträger 5' zusammen mit dem Transporttray um 180° gekippt werden, so dass die Halbleiterbauelemente 7' aus dem Transporttray in die Aufnahmetaschen 6 des Klemmträgers 5' fallen können.

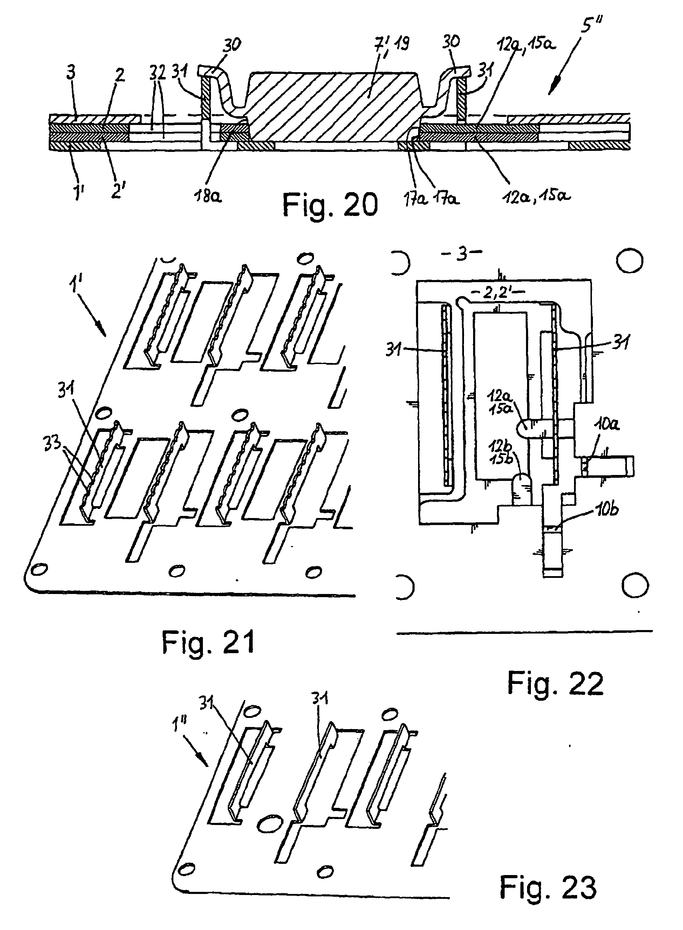

Die Wirkungsweise der beiden Federplatten 2, 2' ist gleich der Wirkungsweise der Federplatte 2 von Figur 1, so dass auf die diesbezüglichen Ausführungen verwiesen wird. Dadurch, dass zwei Federplatten 2, 2' übereinander angeordnet sind, ist es jedoch auf verbesserte Weise möglich, die Drückabschnitte 15a, 15b der Federelemente 12a, 12b und die gegenüberliegenden Anschlagflächen 13a, 13b an Schrägflächen des Halbleiterbauelement-Körpers 19 anzupassen, wie später noch anhand eines alternativen Ausführungsbeispiels von Figur 20 näher beschrieben wird.

Weiterhin ist aus Figur 16 ersichtlich, dass die Federelemente 12a, 12b der Federplatten 2, 2' nicht unbedingt einen U-förmigen Federabschnitt haben müssen, um die notwendige Federkraft aufbringen zu können, sondern dass ein geradliniger Federabschnitt 14a', 14b' genügen kann.

Die Abdeckplatte 3', die bei der Ausführungsform von Figur 16 wiederum als planparallele Platte ausgebildet ist, besteht in diesem Fall aus einer elektrisch nichtleitenden Kunststoffplatte. Die Randbereiche der Abdeckplatte 3' um die Aussparungen 20 herum dienen hierbei als Auflageflächen für die Pins 30. Hierdurch kann vermieden werden, dass sich die Pins 30 zurückbiegen, wenn sie mit einer bestimmten Andrückkraft gegen Kontaktelemente des Testkopfs gedrückt werden.

Figur 20 zeigt einen Querschnitt durch ein weiteres Ausführungsbeispiel eines Klemmträgers 5". Dieser Klemmträger 5" weist wiederum zwei übereinander liegende Federplatten 2, 2' auf, die in gleicher oder ähnlicher Weise wie die Federplatten 2, 2' von Figur 16 ausgebildet sein können. Da sich die übereinander liegenden Federelemente 12a bzw. 12b der beiden Federplatten 2, 2' relativ zueinander bewegen können, können sich die Druckflächen 17a bzw. 17b besonders gut schrägen Seitenflächen des Halbleiterbauelement-Körpers 19 anpassen, wie in Figur 20 dargestellt. Weiterhin können die übereinander angeordneten Anschlagflächen 13a bzw. 13b zueinander seitlich versetzt und dadurch Schrägflächen des Halbleiterbauelements 7' besonders gut angepasst sein.

Wie aus den Figuren 20 bis 22 ersichtlich, weist die Basisplatte 1' bei dieser Ausführungsform Pinabstützelemente 31 auf, die sich durch Aussparungen 32 der Federplatten 2, 2' hindurch erstrecken, um eine Auflage für die Pins 30 zu bilden. Die Pinabstützelemente 31 bestehen hierbei aus Plattenabschnitten, die einstückig aus der Basisplatte 1' geformt und relativ zur Basisplattenebene senkrecht nach oben abgewinkelt sind. Die Pinabstützelemente 31 weisen Einkerbungen 33 auf, in die die einzelnen Pins 30 eingelegt werden können. Hierdurch werden die Pins 30 auch in seitlicher Richtung fixiert.

Figur 23 zeigt ein weiteres Ausführungsbeispiel einer Basisplatte 1". Diese Basisplatte 1" ist ganz ähnlich zur Basisplatte 1' der Figuren 20 bis 22 ausgebildet, hat jedoch an den Pinabstützelementen 31 keine Einkerbungen 33, sondern eine ebene obere Stirnfläche zur Unterstützung der Pins 30.

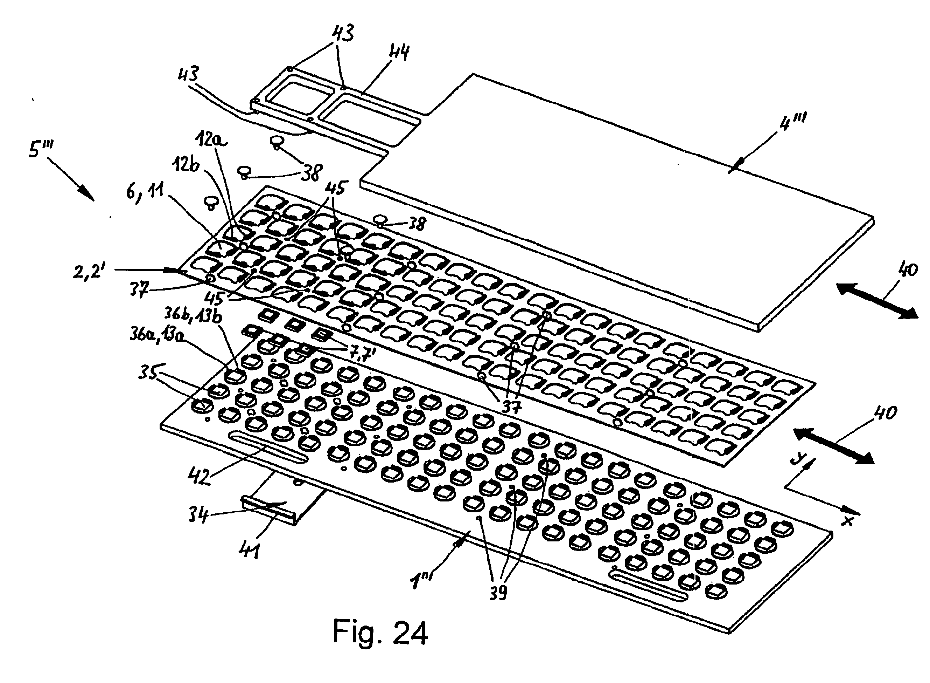

In Figur 24 ist ein weiteres Ausführungsbeispiel der erfindungsgemäßen Vorrichtung schematisch und in Explosionsdarstellung dargestellt. Der Klemmträger 5'" besteht bei diesem Ausführungsform aus einer Basisplatte 1'", einer auf der Basisplatte 1'" verschiebbaren Federplatte 2, 2', die weitgehend identisch zu den Federplatten 2, 2' der vorhergehenden Ausführungsbeispiele ausgebildet sein kann, sowie einer Arretierungsvorrichtung 34 zum Arretieren der Federplatte 2, 2' in einer bestimmten Position relativ zur Basisplatte 1'", wie später noch näher erläutert wird.

Die Basisplatte 1'" weist für jede Aufnahmetasche 6 ein Basiselement 35 mit rechtwinklig zueinander angeordneten Anschlagvorsprüngen 36a, 36b auf, an denen sich die rechtwinklig zueinander angeordneten Anschlagflächen 13a, 13b befinden. Die Anschlagvorsprünge 36a, 36b erstrecken sich bei montierter Federplatte 2, 2' durch die Aussparungen 11 der Federplatte 2, 2' hindurch.

Die Federplatte 2, 2' ist verschiebbar auf der Basisplatte 1'" geführt, so dass sie seitlich, d.h. parallel zu den Ebenen der Basisplatte 1'" bzw. Federplatte 2, 2', definiert verschoben werden kann. Die Federplatte 2, 2' weist hierzu schräg zu ihrer Längsachse angeordneten Langlöcher 37 auf, durch welche Führungszapfen 38 hindurchgeführt werden können. Die Führungszapfen 38 sind mit ihrem unteren Endbereich in Bohrungen 39 der Basisplatte 1'" befestigt. Die Führungszapfen 38 können beispielsweise zylindrische Abschnitte von Nieten oder Schrauben sein. Die Langlöcher 37 der Federplatte 2, 2' sind beim vorliegenden Ausführungsbeispiel in einem Winkel von 45° bzw. 135° zur x-Achse angeordnet. Die Langlöcher 37 bilden zusammen mit den Führungszapfen 38 eine Kulissenführung für die Federplatte 2, 2'. Wird die Federplatte 2, 2' mittels der Betätigungsvorrichtung 4'" in Richtung der Pfeile 40, d.h. in Richtung der x-Koordinate bewegt, so verschiebt sich die Federplatte 2, 2' aufgrund der Kulissenführung gleichzeitig auch in Richtung der y-Koordinate. Durch entsprechendes Verschieben der Federplatte 2, 2' ist es somit möglich, sämtliche Federelemente 12a, 12b der Federplatte 2, 2' gemeinsam aus dem Einführbereich der Halbleiterbauelemente 7, 7' weg zu bewegen und damit die Aufnahmetaschen 6 zu öffnen, so dass die Halbleiterbauelemente 7, 7' in die Aufnahmetaschen 6 eingesetzt werden können, bis sie auf den Basiselementen 35 aufliegen. Wird anschließend die Federplatte 2, 2' in umgekehrter Richtung verschoben, werden die Federelemente 12a, 12b an die eingesetzten Halbleiterbauelemente 7, 7' herangeführt und derart mit diesen in Druckkontakt gebracht, dass sie eine entsprechende Federvorspannung aufbauen können. In dieser Position werden seitliche Haltevorsprünge 41 der Arretierungsvorrichtung 34 durch Schlitze 42 in der Basisplatte 1'" hindurchgeführt und an die Seitenränder der Federplatte 2, 2' angelegt, so dass die Federplatte 2, 2' in dieser Position arretiert wird. Die Federelemente 12a, 12b, die gleich oder ähnlich zu den Federelementen 12a, 12b der vorhergehenden Ausführungsformen ausgebildet sein können, können daher die Bauelemente 37 mittels ihrer Federkraft in der beschriebenen Reihenfolge an die gegenüberliegenden Anschlagvorsprünge 36a, 36b drücken.

Nach Beendigung der Tests werden die Haltevorsprünge 41 der Arretiervorrichtung 34 wieder nach unten zurückgezogen, wodurch die Federplatte 2, 2' frei gegeben wird, so dass die Federplatte 2, 2' mittels der Betätigungsvorrichtung 4'" in umgekehrter Richtung verschoben werden kann und die Federelemente 12a, 12b die Bauelemente 7, 7' freigeben.

Bei dieser Ausführungsform umfasst das Verfahren somit folgender Schritte:
- Öffnen der Aufnahmetaschen 6 durch Verschieben der Federplatte 2, 2,
- Bestücken der Aufnahmetaschen 6 mit den Halbleiterbauelementen 7, 7',
- Heranführen der Federelemente 12a, 12b an die Halbleiterbauelemente 7, 7' und Vorspannen durch Verschieben der Federplatte 2, 2' in umgekehrter Richtung,
- Verriegeln der Position der Federplatte 2, 2' mittels der Arretierungsvorrichtung 34.

Um die Federplatte 2, 2' seitlich zu verschieben, ist die Betätigungsvorrichtung 4'" lösbar mit der Federplatte 2, 2' koppelbar. Die Betätigungsvorrichtung 4'" ist in Figur 24 lediglich schematisch dargestellt und kann beispielsweise Betätigungsstifte 43 aufweisen, die nach unten über ein Rahmenteil 44 vorstehen und mit Bohrungen 45 in der Federplatte 2, 2' in und außer Eingriff gebracht werden können, wenn die Betätigungsvorrichtung 4'" in vertikaler Richtung bewegt wird. Zum Einsetzen und Entfernen der Bauelemente 7, 7' in die bzw. aus den Aufnahmetaschen 6 wird die Betätigungsvorrichtung 4'" derart entfernt, dass das Einsetzen und Entfernen der Halbleiterbauelemente 7, 7' behinderungsfrei möglich ist.

Alternativ zu dem gezeigten Ausführungsbeispiel ist es auch möglich, die Langlöcher 37 nicht geradlinig schräg, sondern bogenförmig auszubilden. Weiter sind auch Langlöcher 37 denkbar, die einen sich in x-Richtung und einen sich in y-Richtung erstreckenden Langlochabschnitt aufweisen, wobei dann die Betätigungsvorrichtung 4'" sowohl in Richtung der x-Koordinate als auch in Richtung der y-Koordinate bewegt wird.

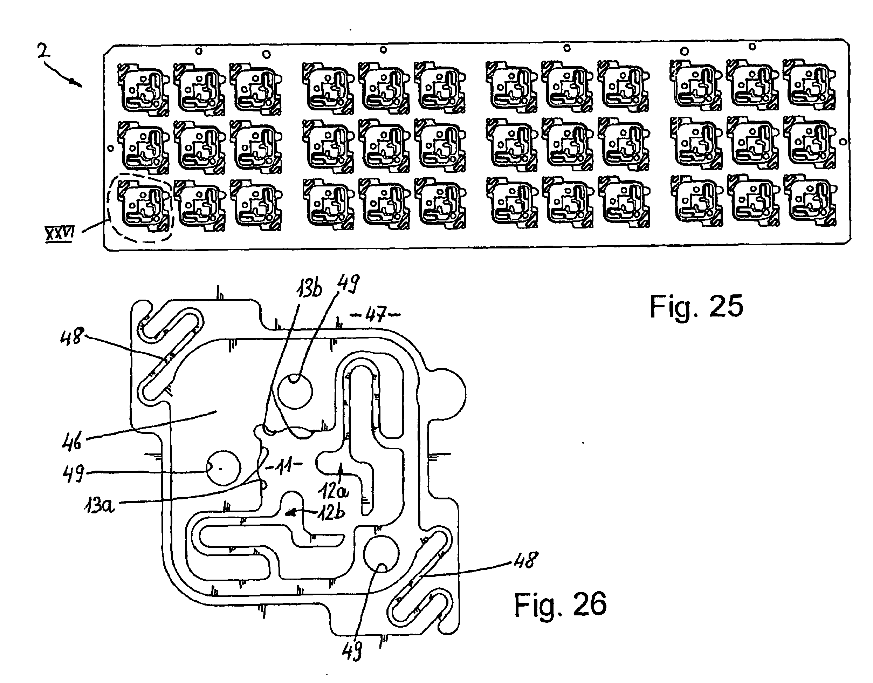

Figur 25 zeigt eine Draufsicht auf eine weitere Ausführungsform einer Federplatte 2, die zusammen mit einer Basisplatte und/oder Abdeckplatte, wie sie im Zusammenhang mit vorhergehenden Ausführungsbeispielen beschrieben worden sind, zu einem mehrlagigen Plattenverbund kombiniert werden kann. Diese Federplatte 2 weist wiederum eine Mehrzahl von Aussparungen 11 auf, in welche singulierte Halbleiterbauelemente 7, 7' eingesetzt und mittels Federelementen 12a, 12b gehalten werden können. Wie aus den Figuren 25, 26 ersichtlich, sind die dortigen Federelemente 12a, 12b gleich oder ganz ähnlich ausgebildet und angeordnet wie diejenigen, die in den Figuren 6 und 7 dargestellt sind. Bezüglich Ausbildung und Wirkungsweise der Federelemente 12a, 12b wird somit auf die entsprechende Beschreibung der ersten Ausführungsform verwiesen. Es ist jedoch auch ohne weiteres möglich, dass die Federelemente 12a, 12b keine unterschiedliche Federkraft, sonder gleiche Federkräfte aufweisen.

Die Anschlagflächen 13a, 13b, gegen welche die eingesetzten Halbleiterbauelemente durch die Federelemente 12a, 12b gedrückt werden, befinden sich bei dieser Ausführungsform direkt an der Federplatte 2. Sowohl diese Anschlagflächen 13a, 13b als auch die Federelemente 12a, 12b sind Teil eines Federplattenabschnitts 46, der vom umgebenden Federplattenkörper 47 rundherum weitgehend separiert und mit diesen nur mittels Aufhängefedern 48 federnd verbunden ist. Im vorliegenden Fall sind zwei Aufhängefedern 48 vorgesehen, die in den diagonal gegenüberliegenden Eckenbereichen eines jeden Federplattenabschnitts 46 angeordnet sind. Die Federplattenabschnitte 46 sind somit im Federplattenkörper 47 schwimmend gelagert, wobei sie sich nach allen Seiten hin relativ zum Federplattenkörper 46 verschieben lassen. Weiterhin weist im dargestellten Ausführungsbeispiel jeder Federplattenabschnitt 46 Zentriermittel in der Form von drei Zentrierlöchern 49 auf. Auf diese Weise ist es möglich, jeden Federplattenabschnitt 46 und die darin aufgenommenen Halbleiterbauelemente auf einfache Weise zu zentrieren, wenn der mit der Federplatte 2 ausgestattete Klemmträger nach Bestückung mit den Halbleiterbauelementen gegen eine Kontaktiervorrichtung, beispielsweise gegen Kontaktsockel oder ein DUT-Board, gefahren werden, wobei dann an diesen Kontaktiervorrichtungen entsprechende Zentrierbolzen vorgesehen sind, die in die Zentrierlöcher 49 eingreifen.

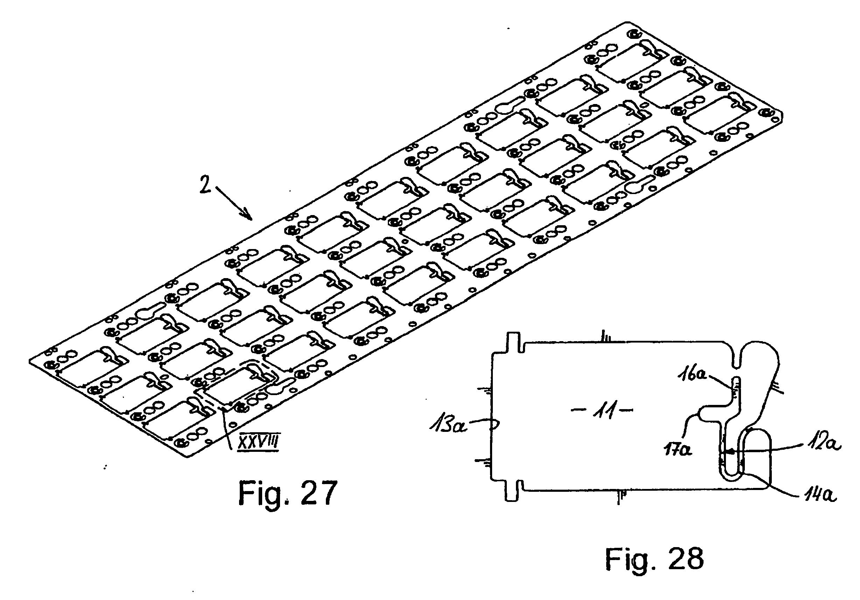

Figur 27 zeigt ein weiteres Ausführungsbeispiel einer Federplatte 2, die wiederum in Kombination mit einer Basisplatte und/oder Abdeckplatte gemäß einer der vorhergehenden Ausführungsformen einen mehrlagigen Plattenverbund ergeben kann. Auch diese Federplatte 2 ist wiederum als planparallele, ebene Platte ausgebildet und weist eine Vielzahl von Aussparungen 11 auf, in welche singulierte Halbleiterbauelemente eingesetzt werden können. Wesentlicher Unterschied zu den vorhergehenden Ausführungsformen ist, dass bei dieser Federplatte 2, wie insbesondere aus Figur 28 ersichtlich, lediglich ein einziges Federelement 12a pro Aufnahmetasche vorgesehen ist. Dieses Federelement 12a kann wiederum in gleicher oder ganz ähnlicher Weise wie das in den Figuren 6 und 7 dargestellte Federelement 12a ausgebildet sein, so dass auf die dortige Beschreibung verwiesen wird. Die Anschlagfläche 13a, gegen die das Halbleiterbauelement gedrückt wird, befindet sich auf der dem Federelement 12a gegenüberliegenden Seite der Aussparung 11. Alternativ hierzu ist es auch ohne weiteres möglich, die Anschlagfläche 13a an der Abdeckplatte oder der Basisplatte vorzusehen, welche beidseitig an die Federplatte 2 angrenzen.

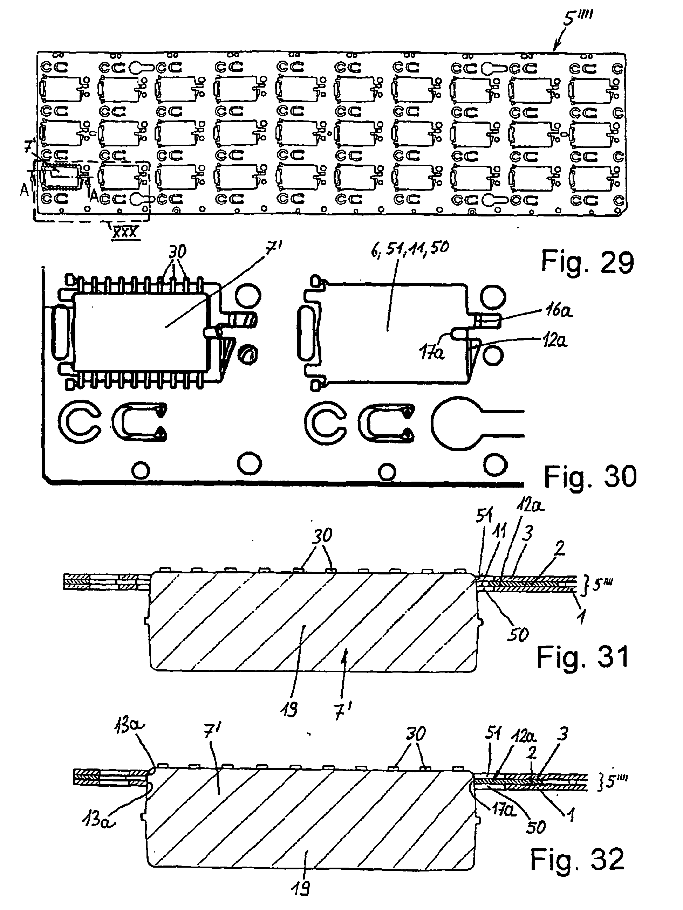

Figur 29 zeigt eine Draufsicht auf ein weiteres Ausführungsbeispiel eines Klemmträgers 5"". Wie aus den Figuren 31, 32 ersichtlich, besteht dieser Klemmträger 5"" aus einem dreilagigen Plattenverbund mit einer Basisplatte 1, einer Federplatte 2 und einer Abdeckplatte 3. Alle drei Platten sind wiederum als planparallele, ebene, dünne Platten ausgebildet, die zweckmäßigerweise die gleichen Längen- und Breitenabmessungen haben.

Im Gegensatz zur Basisplatte 1 der ersten Ausführungsform dient die in den Figuren 31, 32 gezeigte Basisplatte 1 nicht dazu, den Boden für die einzelnen Aufnahmetaschen zu bilden, auf dem die Halbleiterbauelemente aufsitzen. Vielmehr weist die Basisplatte 1 im Bereich jeder Aufnahmetasche eine Aussparung 50 auf, die unterhalb der zugeordneten Aussparung 11 der Federplatte 2 angeordnet ist. Die Abdeckplatte 3, die von oben aus Figur 29 ersichtlich ist, weist eine Aussparung 51 auf, die oberhalb der Aussparung 11 der Federplatte 2 angeordnet ist. Weiterhin sind die Aussparungen 50, 51 so bemessen, dass der Körper 19 eines Halbleiterbauelements 7' hindurchgeführt werden kann, ohne dass er an den seitlichen Rändern der Aussparungen anstößt.

Die Federplatte 2 ist in gleicher oder ähnlicher Weise ausgebildet, wie in den Figuren 27, 28 dargestellt.

Figur 31 zeigt den Plattenverbund im Bereich einer Aufnahmetasche in einem Zustand, in dem das Federelement 12a durch eine geeignete Betätigungsvorrichtung, beispielsweise durch die Betätigungsvorrichtung 4, 4', seitlich nach außen, das heißt in Figur 31 nach rechts, bewegt wurde, so dass ein genügend großer seitlicher Freiraum geschaffen wird, durch den der Körper 19 des Halbleiterbauelements 7' von oben her durch die Aussparungen 51, 11, 50 hindurchgeführt werden kann, bis die Pins 30 des Halbleiterbauelements 7' auf der Oberseite der Abdeckplatte 3 aufliegen. Wird anschließend die Betätigungsvorrichtung von den Federelementen 12a gelöst, drücken diese auf Grund ihrer Vorspannkraft seitlich gegen den Körper 19 des Halbleiterbauelements 7' und verschieben dieses, wie aus Figur 32 ersichtlich, nach links gegen die Anschlagflächen 13a, die sich im vorliegenden Fall sowohl an der Basisplatte 1 als auch an der Abdeckplatte 3 befinden.

Bei dieser Ausführungsform ist es nicht erforderlich, spezielle Pin-Abstützelemente vorzusehen. Vielmehr genügt es, wenn die Oberfläche der Abdeckplatte 3 zumindest an denjenigen Stellen, an denen die Pins 30 auf der Abdeckplatte 3 aufliegen, aus einem nicht leitenden Material besteht. Auch kann die Abdeckplatte 3, wie jede andere Platte, aus einem nicht leitendem Material beschichtetem Federstahlblech bestehen.

Im Rahmen der Erfindung sind eine Vielzahl von Abwandlungen möglich. Insbesondere ist es möglich, die verschiedenen Basisplatten, Federplatten und Abdeckplatten der vorstehend beschriebenen verschiedenen Ausführungsformen in unterschiedlichster Weise miteinander zu kombinieren, um einen Klemmträger für eine Vielzahl singulierter Halbleiterbauelemente zu schaffen, der für den jeweiligen Einsatzzweck optimal ausgelegt ist. Obwohl es in vielen Fällen vorteilhaft sein wird, einen dreilagigen Plattenverbund mit einer Basisplatte, Federplatte und Abdeckplatte zu schaffen, ist es auch denkbar, lediglich einen zweilagigen Plattenverbund oder einen Plattenverbund zu schaffen, der aus mehr als drei Platten besteht. Auch ist es möglich, dass der Klemmträger nur die Federplatte aufweist, also einlagig ausgeführt ist. Die Aufnahmetaschen werden dann nur von den zugeordneten Aussparungen der Federplatte gebildet. Weiterhin müssen die einzelnen Platten, obwohl vorteilhaft, nicht unbedingt die gleichen Breiten- und Längenabmessungen haben. Es ist auch möglich, einzelne Platten zu teilen und die Teilstücke nebeneinander anzuordnen, beispielsweise wenn hierdurch die Fertigung vereinfacht werden kann.

## Patentansprüche

1. Vorrichtung zum Ausrichten und Halten einer Mehrzahl singulierter Halbleiterbauelemente (7, 7'), mit einem plattenartigen Klemmträger (5, 5', 5", 5"', 5"") wobei der Klemmträger aufweist:
- eine Mehrzahl nebeneinander angeordneter Aufnahmetaschen (6), in welche die Halbleiterbauelemente (7, 7') einsetzbar sind,
- Anschlagelemente zum genauen Positionieren der Halbleiterbauelemente (7, 7') innerhalb der Aufnahmetaschen (6),
- Federelemente (12a, 12b) zum Drücken der Halbleiterbauelemente (7, 7') gegen die Anschlagelemente mittels Federkraft,
**dadurch gekennzeichnet, dass** die Federelemente (12a, 12b) Teil einer Federplatte (2, 2') sind, die eine Mehrzahl von nebeneinander angeordneten Aussparungen (11) zur Bildung einer entsprechenden Mehrzahl von Aufnahmetaschen (6) für die Halbleiterbauelemente (7, 7') aufweist, wobei die Federelemente (12a, 12b) einstückig aus der Federplatte (2, 2') geformt sind.

2. Vorrichtung nach Anspruch 1, **dadurch gekennzeichnet, dass** der Klemmträger (5, 5', 5", 5'", 5"") aus einem mehrlagigen Plattenverbund besteht, der die Federplatte (2, 2') und eine zur Federplatte benachbarte Basisplatte (1, 1', 1", 1"', 1"") und/oder Abdeckplatte (3, 3') umfasst, wobei sich die Federplatte (2, 2') zumindest über den überwiegenden Teil der Basisplatte (1, 1', 1", 1"', 1"") oder Abdeckplatte (3, 3') erstreckt.

3. Vorrichtung nach Anspruch 1 oder 2, **dadurch gekennzeichnet, dass** die Federplatte (2, 2') aus einer ebenen Platte besteht, und dass die Federelemente (12a, 12b) aus Federzungen bestehen, die in der Ebene der Federplatte (2, 2') oder parallel zu dieser Ebene angeordnet und bewegbar sind.

4. Vorrichtung nach einem der vorhergehenden Ansprüche, **dadurch gekennzeichnet, dass** der Klemmträger (5, 5', 5", 5"', 5"") pro Aufnahmetasche (6) mindestens zwei winklig zueinander angeordnete Federelemente (12a, 12b) mit unterschiedlich starken Federkräften aufweist, durch welche die Halbleiterbauelemente (7, 7') in zwei unterschiedlichen Richtungen gegen die Anschlagelemente drückbar sind, und dass die Vorrichtung eine Betätigungsvorrichtung (4, 4', 4"') umfasst, die mit den Federelementen (12a, 12b) derart zusammenwirkt, dass das Federelement (12a) mit der schwächeren Federkraft das Halbleiterbauelement (7, 7') zuerst und das Federelement (12b) mit der stärkeren Federkraft das Halbleiterbauelement (7, 7') erst nachfolgend gegen das jeweils zugeordnete, gegenüberliegende Anschlagelement drückt.

5. Vorrichtung nach einem der Ansprüche 2 bis 4, **dadurch gekennzeichnet, dass** eines der folgenden Merkmale erfüllt ist:
- dass die Basisplatte (1) als ebene Platte ausgebildet ist, welche die Böden der Aufnahmetaschen 6) bildet,
- dass die Basisplatte (1) im Bereich der Aufnahmetaschen (6) angeordnete Aussparungen (50) zum Einführen der Halbleiterbauelemente (7') aufweist, wobei sich diese Aussparungen (50) und die Aussparungen (11) der Federplatte (2, 2') überdecken.

6. Vorrichtung nach einem der vorhergehenden Ansprüche, **dadurch gekennzeichnet, dass** die Federplatte (2) pro Aufnahmetasche (6) einen schwimmend befestigten Federplattenabschnitt (46) aufweist, der mit Zentriermitteln versehen ist und mindestens ein Federelement (12a, 12b) sowie die Aussparung (11) zum Einführen des Halbleiterbauelements (7, 7') aufweist.

7. Vorrichtung nach einem der Ansprüche 2 bis 6, **dadurch gekennzeichnet, dass** zumindest eines der folgenden Merkmale erfüllt ist:
dass die Anschlagelemente zum genauen Positionieren der Halbleiterbauelemente (7, 7') an der Abdeckplatte (3) oder Federplatte (2, 2') angeordnet sind,
dass die Abdeckplatte (3, 3') aus einer sich zumindest über den überwiegenden Teil der Federplatte (2, 2') erstreckenden ebenen Platte besteht und Aussparungen (20) aufweist, welche über den Aussparungen (11) der Federplatte (2, 2') angeordnet sind,
dass der Klemmträger (5") zum Aufnehmen von Pins (30) aufweisenden Halbleiterbauelementen (7') ausgebildet ist, wobei die Basisplatte (1') Pinabstützelemente (31) aufweist, die sich durch die Aussparungen (32) der Federplatte (2, 2') hindurch erstrecken, um eine Auflage für die Pins (30) zu bilden, wobei insbesondere
a) der Klemmträger (5') zum Aufnehmen von Pins (30) aufweisenden Halbleiterbauelementen (7') ausgebildet sein kann und
b) die Abdeckplatte (3') aus einem elektrisch isolierenden Material bestehen kann und neben den Aussparungen (20) angeordnete Pinabstützabschnitte aufweisen kann, die eine Auflage für die Pins (30) bilden können.

8. Vorrichtung nach einem der vorhergehenden Ansprüche, **dadurch gekennzeichnet, dass** der Klemmträger (5', 5") zwei oder mehrere übereinander angeordnete Federplatten (2, 2') aufweist, an denen die Federelemente (12a, 12b) angeordnet sind.

9. Vorrichtung nach einem der Ansprüche 4 bis 8, **dadurch gekennzeichnet, dass** die Betätigungsvorrichtung (4, 4') eine parallel zur Klemmträgerebene angeordnete Hauptplatte (26) und von der Hauptplatte (26) abstehende Betätigungsglieder (10a, 10b) aufweist, die bei Annäherung der Betätigungsvorrichtung (4, 4') an den Klemmträger (5, 5', 5") mit den Federelementen (12a, 12b) in Eingriff treten, um diese seitlich nach außen in eine Öffnungsstellung zu drücken.

10. Vorrichtung nach Anspruch 9, **dadurch gekennzeichnet, dass** zumindest eines der folgenden Merkmale erfüllt ist:
dass die Hauptplatte (26) über den Aufnahmetaschen (6) des Klemmträgers (5, 5', 5") angeordnete Zentrieröffnungen (27) zum Hindurchführen und Vorzentrieren der Halbleiterbauelemente (7, 7') aufweist,
dass die Betätigungsglieder (10a, 10b) aus Keilelementen mit Schrägflächen (28a, 28b) bestehen, die mit den Federelementen (12a, 12b) in und außer Eingriff bringbar sind,
dass die Betätigungsglieder (10a, 10b) der Betätigungsvorrichtung (4, 4') derart ausgebildet und relativ zu den Federelementen (12a, 12b) angeordnet sind, dass in einer bestimmten Position der Betätigungsvorrichtung (4, 4') das Federelement (12b) mit der stärkeren Federkraft noch in Druckeingriff mit dem zugeordneten Betätigungsglied (10b) ist, während das Federelement (12a) mit der schwächeren Federkraft bereits außer Druckeingriff mit dem zugeordneten Betätigungsglied (10a) ist.

11. Vorrichtung nach einem der Ansprüche 4 bis 10, **dadurch gekennzeichnet, dass** das Federelement (12a) mit der schwächeren Federkraft eine mit dem Halbleiterbauelement (7, 7') in Kontakt bringbare erste Druckfläche (15a) und das Federelement (12b) mit der stärkeren Federkraft eine mit dem Halbleiterbauelement (7, 7') in Kontakt bringbare zweite Druckfläche (15b) aufweist, wobei die erste Druckfläche (15a) zum gegenüberliegenden Anschlagelement einen kleineren Abstand (A) hat als die zweite Druckfläche (15b) zum gegenüberliegenden Anschlagelement, so dass ein Halbleiterbauelement (7, 7') mit einem quadratischen Körper zuerst vom Federelement (12a) mit der schwächeren Federkraft an das gegenüberliegende Anschlagelement gedrückt wird.

12. Vorrichtung nach einem der Ansprüche 4 bis 8, **dadurch gekennzeichnet, dass** die Federplatte (2, 2') verschiebbar auf der Basisplatte (1"') angeordnet und mittels der Betätigungsvorrichtung (4'") relativ zur Basisplatte (1"') derart verschiebbar ist, dass die Federelemente (12a, 12b) gegen die in die Aufnahmetaschen (6) eingesetzten Halbleiterbauelemente (7,' 7') gedrückt werden, wobei die Federelemente (12a, 12b) vorgespannt werden, wobei insbesondere die Federplatte (2, 2') mittels einer Kulissenführung an der Basisplatte (1'") verschiebbar geführt sein kann.

13. Verfahren zum Ausrichten und Halten von singulierten Halbleiterbauelementen (7, 7') in Aufnahmetaschen (6) eines Klemmträgers (5, 5', 5"), wobei Federelemente (12a, 12b) des Klemmträgers (5, 5', 5") mittels einer Betätigungsvorrichtung (4, 4') in eine das Einsetzen der Halbleiterbauelemente (7, 7') in die Aufnahmetaschen (6) ermöglichende Öffnungsstellung bewegt und nach dem Einsetzen der Halbleiterbauelemente (7, 7') in Druckkontakt mit den Halbleiterbauelemente (7, 7') gebracht werden, um die Halbleiterbauelemente (7, 7') durch die Federkraft der Federelemente (12a, 12b) gegen gegenüberliegende Anschlagelemente zu drücken, **dadurch gekennzeichnet, dass** ein Klemmträger (5, 5', 5") bereit gestellt wird, der pro Aufnahmetasche (6) mindestens zwei winklig zueinander angeordnete Federelemente (12a, 12b) mit unterschiedlich starken Federkräften aufweist, um die Halbleiterbauelemente (7, 7') In zwei unterschiedlichen Richtungen gegen die Anschlagelemente zu drücken, und dass die Betätigungsvorrichtung (4, 4') nach dem Einsetzen der Halbleiterbauelemente (7, 7') in die Aufnahmetaschen (6) von den Federelementen (12a, 12b) derart gelöst wird, dass das Federelement (12a) mit der schwächeren Federkraft das Halbleiterbauelement (7, 7') zuerst und das Federelement (12b) mit der stärkeren Federkraft das Halbleiterbauelement (7, 7') erst nachfolgend gegen das jeweils zugeordnete, gegenüberliegende Anschlagelement drückt.

14. Verfahren zum Ausrichten und Halten von singulierten Halbleiterbauelementen (7, 7') in Aufnahmetaschen (6) eines Klemmträgers (5"'), wobei Federelemente (12a, 12b) des Klemmträgers (5"') mittels einer Betätigungsvorrichtung (4"') in eine das Einsetzen der Halbleiterbauelemente (7, 7') in die Aufnahmetaschen (6) ermöglichende Öffnungsstellung bewegt und nach dem Einsetzen der Halbleiterbauelemente (7, 7') in Druckkontakt mit den Halbleiterbauelemente (7, 7') gebracht werden, um die Halbleiterbauelemente (7, 7') durch die Federkraft der Federelemente (12a, 12b) gegen gegenüberliegende Anschlagelemente zu drücken, **dadurch gekennzeichnet, dass** ein Klemmträger (5"') bereit gestellt wird, der pro Aufnahmetasche (6) mindestens zwei winklig zueinander angeordnete Federelemente (12a, 12b) mit unterschiedlich starken Federkräften aufweist, um die Halbleiterbauelemente (7, 7') in zwei unterschiedlichen Richtungen gegen die Anschlagelemente zu drücken, und dass die winklig zueinander angeordneten Federelemente (12a, 12b) nach dem Einsetzen der Halbleiterbauelemente (7, 7') in die Aufnahmetaschen (6) mittels der Betätigungsvorrichtung (4"') derart verschoben werden, dass das Federelement (12a) mit der schwächeren Federkraft das Halbleiterbauelement (7, 7') zuerst und das Federelement (12b) mit der stärkeren Federkraft das Halbleiterbauelement (7, 7') erst nachfolgend gegen das jeweils zugeordnete, gegenüberliegende Anschlagelement drückt.

15. System zum Testen von einer Mehrzahl von singulierten Halbleiterbauelementen, wobei das System aufweist:
einen Handler für das Testen der Halbleiterbauelemente,
eine Vorrichtung nach einem der Ansprüche 1 bis 12 zum Ausrichten und Halten der Mehrzahl von singulierten Halbleiterbauelementen in dem Handler.

## Claims

1. A device for aligning and holding a plurality of singulated semiconductor components (7, 7') by a plate-like clamping carrier (5, 5', 5", 5"', 5"") wherein the clamping carrier comprises:
- a plurality of receiving pockets (6) arranged side-by-side into which the semiconductor components (7, 7') are insertable,
- stop elements for the accurate positioning of the semiconductor components (7, 7') within the receiving pockets (6),
- spring elements (12a, 12b) for pressing the semiconductor components (7, 7') against the stop elements by spring force,
**characterised in that** the spring elements (12a, 12b) are part of a spring plate (2, 2') which comprises a plurality of recesses (11) arranged side-by-side for forming a corresponding plurality of receiving pockets (6) for the semiconductor components (7, 7'), wherein the spring elements (12a, 12b) are formed from the spring plate (2, 2') in one piece.

2. The device according to Claim 1, **characterised in that** the clamping carrier (5, 5', 5", 5'", 5"") consists of a multi-layer composite plate that comprises the spring plate (2, 2') and, adjacent to the spring plate, a base plate (1, 1', 1", 1"', 1"") and/or cover plate (3, 3'), wherein the spring plate (2, 2') extends over at least the major part of the base plate (1, 1', 1", 1"', 1"") or cover plate (3, 3').

3. The device according to Claim 1 or 2, **characterised in that** the spring plate (2, 2') consists of a flat plate, and **in that** the spring elements (12a, 12b) consist of spring tongues that are arranged and are moveable in the plane of the spring plate (2, 2'), or parallel to this plane.

4. The device according to one of the previous claims, **characterised in that** the clamping carrier (5, 5', 5", 5'", 5"") comprises at least two spring elements (12a, 12b) per receiving pocket (6), arranged at an angle to one another and having with spring forces of different strengths, by which the semiconductor components (7, 7') are pressable against the stop elements in two different directions, and **in that** the device comprises an actuation device (4, 4', 4"') which interacts with the spring elements (12a, 12b) in such a way that the spring element (12a) with the weaker spring force firstly presses the semiconductor component (7, 7') against the opposing stop element respectively assigned, and the spring element (12b) with the stronger spring force only subsequently presses the semiconductor component (7, 7') against the opposing stop element respectively assigned.

5. The device according to one of the Claims 2 to 4, **characterised in that** one of the following features is fulfilled:
- that the base plate (1) is designed as a plan plate that forms the floors of the receiving pockets (6),
- that the base plate (1) comprises recesses (50) arranged in the region of the receiving pockets (6) for the introduction of the semiconductor components (7'), wherein these recesses (50) and the recesses (11) of the spring plate (2, 2') overlap.

6. The device according to one of the previous claims, **characterised in that** the spring plate (2) comprises a spring plate section (46), attached in a floating manner, per receiving pocket (6) which is provided with centring means and comprises at least one spring element (12a, 12b) as well as the recess (11) for the introduction of the semiconductor component (7, 7').

7. The device according to one of the Claims 2 to 6, **characterised in that** at least one of the following features is fulfilled:
that the stop elements for accurate positioning of the semiconductor components (7, 7') are arranged on the cover plate (3) or spring plate (2, 2'),
that the cover plate (3, 3') consists of a plane plate extending over at least the major part of the spring plate (2, 2'), and comprises recesses (20) that are arranged above the recesses (11) of the spring plate (2, 2'),
that the clamping carrier (5") is designed for the accommodation of semiconductor components (7') comprising pins (30), wherein the base plate (1') has pin support elements (31), which extend through the recesses (32) of the spring plate (2, 2') so as to form a support for the pins (30), wherein particularly
a) the clamping carrier (5') can be designed for the accommodation of semiconductor components (7') comprising pins (30) and
b) the cover plate (3') can consist of an electrically insulating material, and can comprise pin support sections arranged alongside the recesses (20), which sections form a support for the pins (30).

8. The device according to one of the previous claims, **characterised in that** the clamping carrier (5', 5") comprises two or multiple spring plates (2, 2') arranged one above the other, on which the spring elements (12a, 12b) are arranged.

9. The device according to one of the Claims 4 to 8, **characterised in that** the actuation device (4, 4') comprises a main plate (26) arranged parallel to the plane of the clamping carrier, and actuators (10a, 10b) protruding from the main plate (26), which in the event of the approach of the actuation device (4, 4') towards the clamping carriers (5, 5', 5") come into engagement with the spring elements (12a, 12b) so as to press the latter laterally outwards into an open position.

10. The device according to Claim 9, **characterised in that** at least one of the following features is fulfilled:
that the main plate (26) comprises centring openings (27) arranged above the receiving pockets (6) of the clamping carrier (5, 5', 5") for guiding through and pre-centre the semiconductor components (7, 7'),
that the actuators (10a, 10b) consist of wedge elements with inclined faces (28a, 28b) that can be brought in and out of engagement with the spring elements (12a, 12b),
that the actuators (10a, 10b) of the actuation device (4, 4') are designed and arranged relative to the spring elements (12a, 12b) such that in a specific position of the actuation device (4, 4') the spring element (12b) with the stronger spring force is still in compressive engagement with the assigned actuator (10b), whereas the spring element (12a) with the weaker spring force is already out of compressive engagement with the assigned actuator (10a).

11. The device according to one of the Claims 4 to 10, **characterised in that** the spring element (12a) with the weaker spring force comprises a first pressure face (15a) that can be brought into contact with the semiconductor component (7, 7'), and the spring element (12b) with the stronger spring force comprises a second pressure face (15b) that can be brought into contact with the semiconductor component (7, 7'), wherein the first pressure face (15a) has a smaller separation distance (A) from the opposing stop element than the second pressure face (15b) has from the opposing stop element, so that a semiconductor component (7, 7') with a square body is pressed firstly by the spring element (12a) with the weaker spring force onto the opposing stop element.

12. The device according to one of the Claims 4 to 8, **characterised in that** the spring plate (2, 2') is moveably arranged on the base plate (1'"), and is moveably relative to the base plate (1'") by the actuation device (4'") in such a way that the spring elements (12a, 12b) are pressed against the semiconductor components (7, 7') inserted into the receiving pockets (6), wherein the spring elements (12a, 12b) are pre-loaded, wherein in particular the spring plate (2, 2') may be moveably guided on the base plate (1'") by a guide rail.

13. A method for aligning and holding singulated semiconductor components (7, 7') in receiving pockets (6) of a clamping carrier (5, 5', 5"), wherein spring elements (12a, 12b) of the clamping carrier (5, 5', 5") are moved by an actuation device (4, 4') into an open position enabling the insertion of the semiconductor components (7, 7') into the receiving pockets (6), and after the insertion of the semiconductor components (7, 7') are brought into compressive contact with the semiconductor components (7, 7') so as to press the semiconductor components (7, 7') by the spring force of the spring elements (12a, 12b) against opposing stop elements, **characterised in that** a clamping carrier (5, 5', 5") is provided that comprises at least two spring elements (12a, 12b) per receiving pocket (6) arranged at an angle to one another with spring forces of different strengths, so as to press the semiconductor components (7, 7') in two different directions against the stop elements, and **in that** the actuation device (4, 4') after the insertion of the semiconductor components (7, 7') into the receiving pockets (6) is released from the spring elements (12a, 12b) such that the spring element (12a) with the weaker spring force firstly presses the semiconductor component (7, 7') against the opposing stop element respectively assigned, and the spring element (12b) with the stronger spring force only subsequently presses the semiconductor component (7, 7') against the opposing stop element respectively assigned.

14. A method for aligning and holding singulated semiconductor components (7, 7') in receiving pockets (6) of a clamping carrier (5"'), wherein spring elements (12a, 12b) of the clamping carrier (5"') are moved by an actuation device (4"') into an open position enabling the insertion of the semiconductor components (7, 7') into the receiving pockets (6), and after the insertion of the semiconductor components (7, 7') are brought into compressive contact with the semiconductor components (7, 7') so as to press the semiconductor components (7, 7') by the spring force of the spring elements (12a, 12b) against opposing stop elements, **characterised in that** a clamping carrier (5"') is provided that comprises at least two spring elements (12a, 12b) per receiving pocket (6) arranged at an angle to one another with spring forces of different strengths so as to press the semiconductor components (7, 7') in two different directions against the stop elements, and **in that** the spring elements (12a, 12b) arranged at an angle to one another after the insertion of the semiconductor components (7, 7') into the receiving pockets (6) are displaced by the actuation device (4"') in such a way that the spring element (12a) with the weaker spring force firstly presses the semiconductor component (7, 7') against the opposing stop element respectively assigned, and the spring element (12b) with the stronger spring force only subsequently presses the semiconductor component (7, 7') against the opposing stop element respectively assigned.

15. A system for testing a plurality of singulated semiconductor components, wherein the system comprises:
a handler for the testing of the semiconductor components;
a device according to one of the Claims 1 to 12 for aligning and holding the plurality of singulated semiconductor components in the handler.

## Revendications

1. Dispositif pour orienter et maintenir une pluralité de composants semi-conducteurs (7, 7') singuliers avec un support de serrage (5, 5', 5", 5"', 5"") de type plaque, le support de serrage présentant :
- une pluralité de poches de réception (6) disposées les unes à côté des autres, dans lesquelles les composants semi-conducteurs (7, 7') peuvent être insérés,
- des éléments de butée pour le positionnement précis des composants semi-conducteurs (7, 7') dans les poches de réception (6),
- des éléments de ressort (12a, 12b) pour presser les composants semi-conducteurs (7, 7') contre les éléments de butée à l'aide de la force de ressort,
**caractérisé en ce que** les éléments de ressort (12a, 12b) font partie d'une plaque de ressort (2, 2') qui présente une pluralité d'évidements (11) disposés les uns à côté des autres pour la formation d'une pluralité correspondante de poches de réception (6) pour les composants semi-conducteurs (7, 7'), les éléments de ressort (12a, 12b) étant formés d'un seul tenant dans la plaque de ressort (2, 2').

2. Dispositif selon la revendication 1, **caractérisé en ce que** le support de serrage (5, 5', 5", 5"', 5"") se compose d'un assemblage de plaque multicouche qui comporte la plaque de ressort (2, 2') et une plaque de base (1, 1', 1", 1"', 1"") contiguë à la plaque de ressort et/ou une plaque de recouvrement (3, 3'), la plaque de ressort (2, 2') s'étendant au moins sur la partie principale de la plaque de base (1, 1', 1", 1"', 1"") ou plaque de recouvrement (3, 3').

3. Dispositif selon la revendication 1 ou 2, **caractérisé en ce que** la plaque de ressort (2, 2') se compose d'une plaque plane et **en ce que** les éléments de ressort (12a, 12b) se composent de lames de ressort qui sont disposées et sont mobiles dans le plan de la plaque de ressort (2, 2') ou parallèlement à ce plan.

4. Dispositif selon l'une quelconque des revendications précédentes, **caractérisé en ce que** le support de serrage (5, 5', 5", 5"', 5"") présente par poche de réception (6), au moins deux éléments de ressort (12a, 12b) disposés de manière angulaire l'un par rapport à l'autre avec des forces de ressort différemment fortes, par lesquels les composants semi-conducteurs (7, 7') peuvent être pressés dans deux directions différentes contre les éléments de butée et **en ce que** le dispositif comporte un dispositif d'actionnement (4, 4', 4"') qui coopère avec les éléments de ressort (12a, 12b) de telle sorte que l'élément de ressort (12a) avec la force de ressort la plus faible presse tout d'abord le composant semi-conducteur (7, 7') et l'élément de ressort (12b) avec la force de ressort plus forte ne presse qu'ensuite le composant semi-conducteur (7, 7') contre l'élément de butée opposé, associé respectivement.

5. Dispositif selon l'une quelconque des revendications 2 à 4, **caractérisé en ce que** l'une des caractéristiques suivantes est satisfaite :
- **en ce que** la plaque de base (1) est réalisée comme une plaque plane qui forme les fonds des poches de réception (6),
- **en ce que** la plaque de base (1) présente des évidements (50) disposés dans la zone des poches de réception (6) pour l'introduction des composants semi-conducteurs (7'), ces évidements (50) et les évidements (11) de la plaque de ressort (2, 2') se recouvrant.

6. Dispositif selon l'une quelconque des revendications précédentes, **caractérisé en ce que** la plaque de ressort (2) présente par poche de réception (6) une section de plaque de ressort (46) fixée de manière flottante, qui est pourvue de moyens de centrage et présente au moins un élément de ressort (12a, 12b) ainsi que l'évidement (11) pour l'introduction du composant semi-conducteur (7, 7').

7. Dispositif selon l'une quelconque des revendications 2 à 6, **caractérisé en ce qu'**au moins l'une des caractéristiques suivantes est satisfaite :
**en ce que** les éléments de butée sont disposés pour le positionnement précis des composants semi-conducteurs (7, 7') sur la plaque de recouvrement (3) ou la plaque de ressort (2, 2'),
**en ce que** la plaque de recouvrement (3, 3') se compose d'une plaque plane s'étendant au moins sur la partie principale de la plaque de ressort (2, 2') et présente des évidements (20) qui sont disposés sur les évidements (11) de la plaque de ressort (2, 2'),
**en ce que** le support de serrage (5") est réalisé pour la réception des composants semi-conducteurs (7') présentant des broches (30), la plaque de base (1') présentant des éléments d'appui de broche (31) qui s'étendent par les évidements (32) de la plaque de ressort (2, 2') afin de former un appui pour les broches (30), en particulier
a) le support de serrage (5') pouvant être réalisé pour recevoir des composants semi-conducteurs (7') présentant des broches (30) et
b) la plaque de recouvrement (3') pouvant se composer d'un matériau isolant et pouvant présenter des sections d'appui de broches disposées à côté des évidements (20), qui peuvent former un appui pour les broches (30).

8. Dispositif selon l'une quelconque des revendications précédentes, **caractérisé en ce que** le support de serrage (5', 5") présente deux ou plusieurs plaques de ressort (2, 2') disposées les unes au-dessus des autres, sur lesquelles sont disposés les éléments de ressort (12a, 12b).

9. Dispositif selon l'une quelconque des revendications 4 à 8, **caractérisé en ce que** le dispositif d'actionnement (4, 4') présente une plaque principale (26) disposée parallèlement au plan de support de serrage et des organes d'actionnement (10a, 10b) dépassant de la plaque principale (26) qui viennent en prise lors de l'approche du dispositif d'actionnement (4, 4') du support de serrage (5, 5', 5") avec les éléments de ressort (12a, 12b) afin de les presser latéralement vers l'extérieur dans une position d'ouverture.

10. Dispositif selon la revendication 9, **caractérisé en ce qu'**au moins l'une des caractéristiques suivantes est satisfaite :
**en ce que** la plaque principale (26) présente des ouvertures de centrage (27) disposées au-dessus des poches de réception (6) du support de serrage (5, 5', 5") pour passer à travers et précentrer les composants semi-conducteurs (7, 7')
**en ce que** les organes d'actionnement (10a, 10b) se composent d'éléments de coin avec des surfaces de biais (28a, 28b) qui peuvent être amenées en et hors engagement avec les éléments de ressort (12a, 12b),
**en ce que** les organes d'actionnement (10a, 10b) du dispositif d'actionnement (4, 4') sont réalisés et disposés par rapport aux éléments de ressort (12a, 12b) de telle sorte que dans une position déterminée du dispositif d'actionnement (4, 4'), l'élément de ressort (12b) avec la force de ressort plus forte est encore en engagement de pression avec l'organe d'actionnement (10b) associé, alors que l'élément de ressort (12a) avec la force de ressort plus faible est déjà hors engagement de pression avec l'organe d'actionnement (10a) associé.

11. Dispositif selon l'une quelconque des revendications 4 à 10, **caractérisé en ce que** l'élément de ressort (12a) avec la force de ressort plus faible présente une première surface de pression (15a) pouvant être amenée en contact avec le composant semi-conducteur (7, 7') et l'élément de ressort (12b) avec la force de ressort plus forte présente une seconde surface de pression (15b) pouvant être amenée en contact avec le composant semi-conducteur (7, 7'), la première surface de pression (15a) ayant une plus petite distance (A) par rapport à l'élément de butée opposé que la seconde surface de pression (15b) par rapport à l'élément de butée opposé de sorte qu'un composant semi-conducteur (7, 7') avec un corps carré soit pressé tout d'abord par l'élément de ressort (12a) avec la force de ressort plus faible sur l'élément de butée opposé.

12. Dispositif selon l'une quelconque des revendications 4 à 8, **caractérisé en ce que** la plaque de ressort (2, 2') est disposée de manière coulissante sur la plaque de base (1"') et peut être coulissée à l'aide du dispositif d'actionnement (4"') par rapport à la plaque de base (1"') de telle sorte que les éléments de ressort (12a, 12b) soient pressés contre les composants semi-conducteurs (7, 7') insérés dans les poches de réception (6), les éléments de ressort (12a, 12b) étant précontraints, en particulier la plaque de ressort (2, 2') pouvant être guidée de manière coulissante à l'aide d'une coulisse sur la plaque de base (1"').

13. Procédé pour orienter et maintenir des composants semi-conducteurs singuliers (7, 7') dans des poches de réception (6) d'un support de serrage (5, 5', 5"), des éléments de ressort (12a, 12b) du support de serrage (5, 5', 5") étant déplacés à l'aide d'un dispositif d'actionnement (4, 4') dans une position d'ouverture permettant l'insertion des composants semi-conducteurs (7, 7') dans les poches de réception (6) et étant amenés après l'insertion des composants semi-conducteurs (7, 7') en contact de pression avec les composants semi-conducteurs (7, 7') afin de presser les composants semi-conducteurs (7, 7') par la force de ressort des éléments de ressort (12a, 12b) contre des éléments de butée opposés, **caractérisé en ce qu'**un support de serrage (5, 5', 5") est mis à disposition, lequel présente par poche de réception (6) au moins deux éléments de ressort (12a, 12b) disposés de manière angulaire l'un par rapport à l'autre avec des forces de ressort différemment fortes afin de presser les composants semi-conducteurs (7, 7') dans deux directions différentes contre les éléments de butée et **en ce que** le dispositif d'actionnement (4, 4') est détaché après l'insertion des composants semi-conducteurs (7, 7') dans les poches de réception (6) des éléments de ressort (12a, 12b) de telle sorte que l'élément de ressort (12a) avec la force de ressort plus faible presse tout d'abord le composant semi-conducteur (7, 7') et l'élément de ressort (12b) avec la force de ressort plus forte ne presse qu'ensuite le composant semi-conducteur (7, 7') contre l'élément de butée opposé, associé respectivement.

14. Procédé pour orienter et maintenir des composants semi-conducteurs singuliers (7, 7') dans des poches de réception (6) d'un support de serrage (5"'), des éléments de ressort (12a,12b) du support de serrage (5"') étant déplacés à l'aide d'un dispositif d'actionnement (4"') dans une position d'ouverture permettant l'insertion des composants semi-conducteurs (7, 7') dans les poches de réception (6) et étant amenés après l'insertion des composants semi-conducteurs (7, 7') en contact de pression avec les composants semi-conducteurs (7, 7') afin de presser les composants semi-conducteurs (7, 7') par la force de ressort des éléments de ressort (12a, 12b) contre des éléments de butée opposés, **caractérisé en ce qu'**un support de serrage (5"') est mis à disposition, lequel présente par poche de réception (6) au moins deux éléments de ressort (12a, 12b) disposés de manière angulaire l'un par rapport à l'autre avec des forces de ressort différemment fortes afin de presser les composants semi-conducteurs (7, 7') dans deux directions différentes contre les éléments de butée et **en ce que** les éléments de ressort (12a, 12b) disposés de manière angulaire l'un par rapport à l'autre sont déplacés après l'insertion des composants semi-conducteurs (7, 7') dans les poches de réception (6) à l'aide du dispositif d'actionnement (4"') de telle sorte que l'élément de ressort (12a) avec la force de ressort plus faible presse tout d'abord le composant semi-conducteur (7, 7') et l'élément de ressort (12b) avec la force de ressort plus forte ne presse qu'ensuite le composant semi-conducteur (7, 7') contre l'élément de butée opposé, associé respectivement.

15. Système pour tester une pluralité de composants semi-conducteurs singuliers, le système présentant :
un programme de traitement pour tester les composants semi-conducteurs,
un dispositif selon l'une quelconque des revendications 1 à 12 pour orienter et maintenir la pluralité de composants semi-conducteurs singuliers dans le programme de traitement.
